# EUROPEAN PATENT APPLICATION

(11) **EP 4 694 611 A1**
(43) Date of publication of application: **11.02.2026**
(21) Application number: 25191401.6
(22) Date of filing: 23.07.2025
(51) Int. Cl.: H10B 12/00

(54) **SEMICONDUCTOR MEMORY DEVICE AND METHOD FOR FABRICATING THE SAME**

(30) Priority: 08.08.2024 KR 20240106210
(71) Applicant: Samsung Electronics Co., Ltd., Suwon-si, Gyeonggi-do 16677 (KR)
(72) Inventor: LEE, Kyeong Gyu, 16677 Suwon-si (KR); KUH, Bong Jin, 16677 Suwon-si (KR); KIM, Jung Taek, 16677 Suwon-si (KR); CHOI, Won Hee, 16677 Suwon-si (KR)
(74) Representative: Marks & Clerk LLP

(57) **Abstract**

A semiconductor memory device includes a substrate; a plurality of semiconductor patterns on the substrate and spaced apart from each other in a first direction perpendicular to an upper surface of the substrate; a plurality of interlayer insulating patterns between adjacent semiconductor patterns in the first direction; and data storage devices on the plurality of semiconductor patterns, wherein the plurality of semiconductor patterns include at least one dummy pattern and a plurality of channel patterns, and the at least one dummy pattern includes a first element with a smaller atomic size than silicon.

## Description

### FIELD

The present disclosure relates to a semiconductor memory device, and more specifically, to a three-dimensional (3D) semiconductor memory device with improved electrical characteristics and a method for fabricating the 3D semiconductor memory device.

### BACKGROUND

To meet consumer demands for superior performance and low cost, it may be necessary to increase the integration density of semiconductor devices. In the case of semiconductor devices, the integration density is a critical factor in determining the products' price, and therefore, especially high integration density is required.

In conventional two-dimensional (2D) or planar semiconductor devices, the integration density is primarily determined by the area occupied by each unit memory cell, and is therefore greatly influenced by the level of fine patterning technology. However, since cost-prohibitive equipment is required for fine patterning, the integration density of 2D semiconductor devices is increasing but remains limited. Accordingly, 3D semiconductor memory devices with memory cells arranged three-dimensionally have been proposed.

### SUMMARY

Aspects of the present disclosure provide a semiconductor memory device with improved product reliability.

Aspects of the present disclosure also provide a method for fabricating a semiconductor memory device with improved product reliability.

Aspects of the present disclosure are not restricted to those set forth herein. The above and other aspects of the present disclosure will become more apparent to one of ordinary skill in the art to which the present disclosure pertains by referencing the detailed description of the present disclosure given below.

According to some embodiments of the present disclosure, a semiconductor memory device includes a substrate, a plurality of semiconductor patterns on the substrate and spaced apart from each other in a first direction parallel to an upper surface of the substrate, a plurality of interlayer insulating patterns respectively between adjacent ones of the plurality of semiconductor patterns in a third direction, and a plurality of data storage devices electrically connected to respective ones of the plurality of semiconductor patterns, wherein the plurality of semiconductor patterns includes at least one dummy pattern and a plurality of active patterns, and the at least one dummy pattern includes a first element with an atomic radius that is less than an atomic radius of silicon.

According to some embodiments of the present disclosure, a semiconductor memory device includes a substrate, a plurality of semiconductor patterns on the substrate and spaced apart from each other in a first direction parallel to an upper surface of the substrate, a plurality of wordlines electrically connected to respective ones of the plurality of semiconductor patterns, a plurality of bitlines electrically connected to a plurality of first ends of the plurality of semiconductor patterns, respectively, and a plurality of data storage devices electrically connected to respective ones of a plurality of second ends of the plurality of semiconductor patterns, wherein the plurality of semiconductor patterns includes at least one dummy pattern and a plurality of active patterns, the at least one dummy pattern is on a respective at least one upper side and/or on a respective at least one lower side of the plurality of active patterns, and the at least one dummy pattern includes a first element with an atomic radius that is less than an atomic radius of silicon.

According to some embodiments of the present disclosure, a method for fabricating a semiconductor memory device, includes forming a mold structure that includes a dummy region and a cell region, and includes a plurality of sacrificial films and a plurality of semiconductor films alternately stacked on a substrate, the plurality of semiconductor films includes at least one dummy film in the dummy region and a plurality of active films in the cell region, forming a plurality of horizontal regions between the plurality of semiconductor films by removing the plurality of sacrificial films, and forming a plurality of semiconductor patterns by etching a plurality of upper surfaces and a plurality of lower surfaces of the plurality of semiconductor films exposed by the plurality of horizontal regions, the plurality of semiconductor patterns includes at least one dummy pattern formed by etching the at least one dummy film and a plurality of active patterns formed by etching the plurality of active films, wherein the plurality of sacrificial films includes a compressive stress material, and the plurality of dummy films includes a tensile stress material.

At least some of the above and other features of the invention are set out in the claims. It should be noted that the effects of the present disclosure are not limited to those described above, and other effects of the present disclosure will be apparent from the following description.

### BRIEF DESCRIPTION OF THE DRAWINGS

Embodiments will be more clearly understood from the following detailed description taken in conjunction with the accompanying drawings, in which:
FIG. 1 is a schematic circuit diagram illustrating the cell array of a three-dimensional (3D) semiconductor memory device according to some embodiments;
FIG. 2 is an perspective view of a semiconductor memory device according to some embodiments;
FIG. 3 is a plan view for a semiconductor memory device according to some embodiments;
FIG. 4 includes cross-sectional views taken along lines A-A and B-B of FIG. 3;
FIG. 5 includes cross-sectional views taken along lines C-C and D-D of FIG. 3;
FIGS. 6-12 are cross-sectional views of semiconductor memory devices according to some embodiments;
FIG. 13 is a diagram of the active patterns of semiconductor memory devices according to example embodiments.
FIG. 14 is a graphical representation of the concentration of C within the active patterns according to example embodiments;
FIGS. 15-43 are diagrams of a method for fabricating a semiconductor device according to some embodiments;
FIGS. 44-46 are diagrams of methods for fabricating a semiconductor device according to some embodiments;
FIG. 47 is a perspective view of a semiconductor memory device according to some embodiments;
FIG. 48 is a perspective view of a semiconductor memory device according to some embodiments; and
FIGS. 49-56 are cross-sectional views of semiconductor memory devices according to some embodiments.

### DETAILED DESCRIPTION

Hereinafter, example embodiments will be described with reference to the accompanying drawings.

The term "first," "second," or the like used herein may modify various elements regardless of the order and/or priority thereof, and is used only for distinguishing one element from another element, without limiting example embodiments. The terms "comprises," "comprising," "includes" and/or "including," when used herein, specify the presence of stated elements, but do not preclude the presence of additional elements. The term "and/or" used herein, includes any and all combinations of one or more of the associated listed items. The term "connected," when used herein, specify electrical and/or physical connection between elements or components. As used herein, the singular forms "a", "an", and "the" are intended to include the plural forms as well, unless the context clearly indicates otherwise. Additionally, the description may be specific to a portion of the semiconductor device and the described structure may be repeated in other portions of the semiconductor device. For example, the described structure may be an individual element of an array of elements forming the semiconductor device. Accordingly, where the structure of a single element of a plurality of elements has been described, this structure may equally apply to other elements of the plurality of elements.

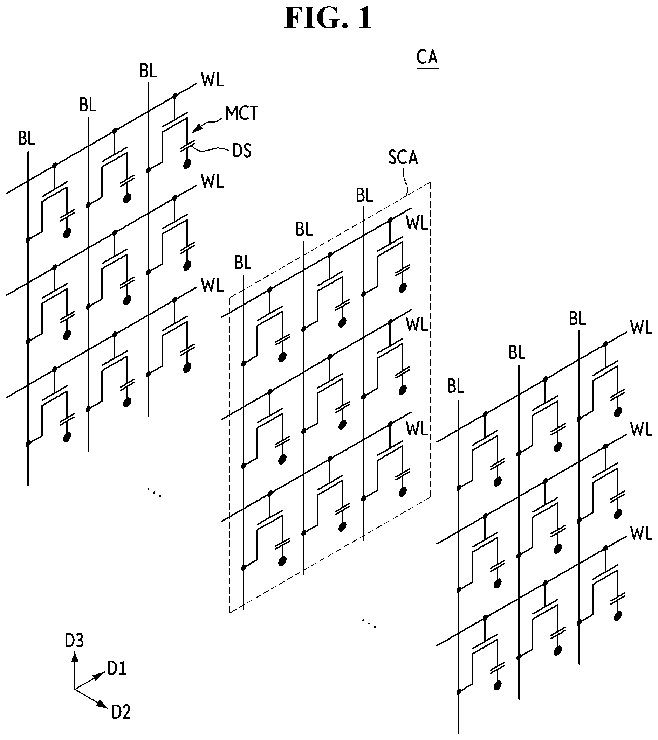

FIG. 1 is a schematic circuit diagram illustrating the cell array of a three-dimensional (3D) semiconductor memory device according to some embodiments.

Referring to FIG. 1, a cell array CA of the 3D semiconductor memory device according to some embodiments may include a plurality of sub-cell arrays SCA. The sub-cell arrays SCA may be arranged along a second direction D2.

Each of the sub-cell arrays SCA may include a plurality of bitlines BL, a plurality of wordlines WL, a plurality of memory cells, and a plurality of memory cell transistors MCT. A memory cell transistor MCT may be between one wordline WL and one bitline BL. In other words, the memory cell transistor MCT may be electrically connected between a wordline WL and a bitline BL. In example embodiments, the memory cell transistor may be configured such that the source is electrically connected to the capacitor, the drain is electrically connected to the bitline, and the gate is electrically connected to the wordline, but the present disclosure is not limited thereto.

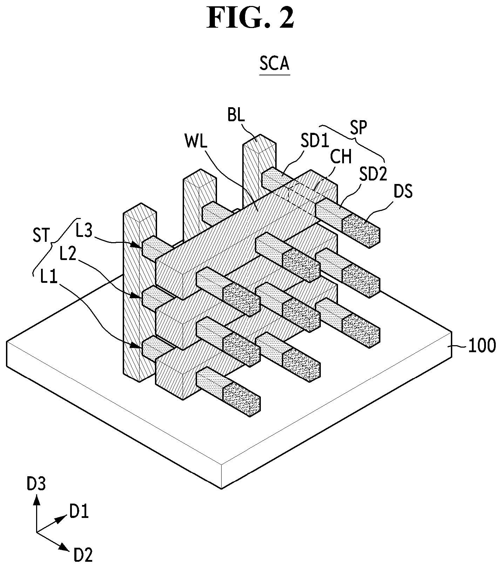

Referring to FIG. 2, the bitlines BL within each of the sub-cell arrays SCA may be conductive patterns (e.g. metallic conductive lines) that extend in a direction perpendicular to a substrate (i.e. in a third direction D3). The bitlines BL may be arranged in a first direction D1. Adjacent bitlines BL may be spaced apart from each other in the first direction D1.

The wordlines WL may be conductive patterns (e.g. metallic conductive lines) that are stacked in the third direction D3 on the substrate 100. Each of the wordlines WL may extend in the first direction D1. Adjacent wordlines WL may be spaced apart from each other in the third direction D3.

The gates of the memory cell transistors MCT may be electrically connected to the wordlines WL, and the first sources/drains of the memory cell transistors MCT may be electrically connected to the bitlines BL. The second sources/drains of the memory cell transistors MCT may be electrically connected to data storage devices DS. For example, the data storage devices DS may be capacitors. In example embodiments, the capacitors may be non-polarized capacitors, however the present disclosure is not limited thereto, and data storage devices DS may be any combination and/or variation thereof including polarized, non-polarized, and variable capacitors. The second sources/drains SD2 of the memory cell transistors MCT may be electrically connected to storage electrodes SE of the capacitors CAP, as illustrated in FIGS. 1-3. In other words, the first and second impurity regions SD1 and SD2 of FIG. 2 may correspond to the first and second sources/drains, respectively, of each of the memory cell transistors MCT of FIG. 1. The data storage devices DS of FIG. 2 may include capacitors CAP, and the capacitors CAP may include capacitor dielectric films CIL, the storage electrodes SE, and plate electrodes PE. In example embodiments, the second sources/drains SD2 of the memory cell transistors MCT may be electrically connected to storage electrodes SE in the data storage devices DS, as illustrated in FIG. 2. In particular embodiments, the semiconductor memory device is a random access memory (RAM) device, such as a dynamic RAM (DRAM) device, a magnetoresistive RAM (MRAM) device, a resistive RAM (reRAM) device, or a phase change memory (PCM). Having said this, embodiments are not limited to RAM, and alternative forms of semiconductor memory device are possible, such as flash memory. That is, while particular embodiments include capacitors as the data storage devices DS, alternative forms of data storage device are possible. The semiconductor memory device may be a volatile memory device or a non-volatile memory device.

FIG. 2 is a perspective view illustrating the semiconductor memory device according to some embodiments.

Referring to FIGS. 1 and 2, one of the sub-cell arrays SCA may be on a substrate 100.

The substrate 100 may be a bulk silicon (Si) substrate or an Si-on-insulator (SOI) substrate. In some embodiments, the substrate 100 may be an Si substrate, or may include other materials such as silicon-germanium (SiGe), SiGe-on-insulator (SGOI), indium antimonide, a lead telluride compound, indium arsenide, indium phosphide, gallium arsenide, or gallium antimonide, but the present disclosure is not limited thereto. The substrate 100 will hereinafter be described as being a substrate containing Si, as a non-limiting example.

Here, the first, second, and third directions corresponding to D1, D2, and D3, respectively, may intersect one another (e.g. may be perpendicular to each other). Additionally, the first direction D1 and the second direction D2 may be parallel to the upper surface of the substrate 100, and the third direction D3 may be perpendicular to the upper surface of the substrate 100. The first direction D1 and the second direction D2 may be horizontal directions. Upper surfaces, lower surfaces, upper sides, and lower sides may be defined by the third direction D3 (i.e. the vertical direction). The sub-cell arrays SCA may be formed on the upper surface of the substrate 100. It will be appreciated that the relative positions described herein are defined relative to the structure of the device. Accordingly, they need not limit the device to use in any particular orientation.

A stack structure ST, including first, second, and third layers corresponding to L1, L2, and L3, respectively, may be on the substrate 100 (e.g. on the upper surface of the substrate). The first, second, and third layers, respectively L1, L2, and L3 of the stack structure ST, may be stacked in the direction perpendicular to the upper surface of the substrate 100 (i.e. in the third direction D3) to be spaced apart from one another. In some embodiments, the first, second, and third layers L1, L2, and L3 of the stack structure ST may be stacked in the thickness direction of the substrate 100 (i.e. in the third direction D3) to be spaced apart from one another. The number of layers L in the stack structure ST is not limited. In other words, the number of layers L may refer to any number of layers L1-LN where N can be any whole number integer greater than 1. Each of the first, second, and third layers L1, L2, and L3, respectively, may include a plurality of semiconductor patterns SP, a plurality of data storage devices DS, and a plurality of wordlines WL.

The semiconductor patterns SP may have a linear or bar shape extending in the second direction D2. A plurality of semiconductor patterns SP located at the same vertical level (i.e. in the direction D3) may be arranged in the first direction D1. For example, the semiconductor patterns SP of the first layer L1 may be positioned at the same vertical level (e.g. in the direction D3) and may be arranged in the first direction D1.

The semiconductor patterns SP may include a semiconductor material such as Si, germanium (Ge), or SiGe. In example embodiments, the semiconductor patterns SP may include at least one of polysilicon, polysilicon-Ge, monocrystalline Si, or monocrystalline SiGe.

Each of the semiconductor patterns SP may include a channel region CH, a first impurity region SD1, and a second impurity region SD2. The channel region CH may be interposed between the first and second impurity regions SD1 and SD2. The channel region CH may correspond to the channel of each of the memory cell transistors MCT of FIG. 1. The first and second impurity regions SD1 and SD2 may correspond to the first and second sources/drains, respectively, of each of the memory cell transistors MCT of FIG. 1.

The first and second impurity regions SD1 and SD2 may be regions where impurities are doped into the corresponding semiconductor pattern SP. Thus, the first and second impurity regions SD1 and SD2 may have n-type or p-type conductivity. The first impurity region SD1 may be formed at a first end of the corresponding semiconductor pattern SP, and the second impurity regions SD2 may be formed at a second end of the corresponding semiconductor pattern SP. The second end may be opposite to the first end in the second direction D2.

The first impurity region SD1 may be formed adjacent to and connected (electrically and/or physically) to one of the bitlines BL. The second impurity region SD2 may be formed adjacent to and connected (electrically and/or physically) to one of the data storage devices DS.

The data storage devices DS may be memory elements capable of storing data. Each data storage device DS may be a memory element using a capacitor, a memory element using a magnetic tunnel junction (MTJ) pattern, or a memory element using a variable resistor containing a phase-change material. In example embodiments, each of the data storage devices DS may be a capacitor.

The wordlines WL may have a linear or bar shape extending in the first direction D1. The wordlines WL may be stacked to be spaced apart from each other in the third direction D3. The wordlines WL may be on at least portions of the perimeter surfaces of the channel regions CH of the semiconductor patterns SP. The wordlines WL may extend in the first direction D1, crossing the semiconductor patterns SP within a single layer.

In some embodiments, the wordlines WL may each extend in the first direction D1 and be on the semiconductor patterns SP that are at the same vertical level (i.e. in the direction D3). The semiconductor patterns SP may be spaced apart from each other in the first direction D1. The wordlines WL may each extend in the first direction D1 and intersect the semiconductor patterns SP that are at the same vertical level (i.e. in the direction D3). The semiconductor patterns SP may be spaced apart from each other in the first direction D1. The width, in the first direction D1, of the wordlines WL may be greater than the width, in the first direction D1, of the semiconductor patterns SP. Each semiconductor pattern SP may have a convex shape in the first direction. For instance, at least a portion of one of or both sidewalls of the semiconductor pattern SP may be convex (e.g. may protrude in the first direction D1). The convex shape may be at a portion of the semiconductor pattern SP that overlaps with the corresponding wordline WL. Accordingly, a portion of the semiconductor pattern SP that overlaps with the corresponding wordline WL may have a larger width in the first direction D1 than a portion that does not overlap with the corresponding wordline WL.

For example, the semiconductor patterns SP of the first layer L1 may be arranged in the first direction D1, the bitlines BL may be connected to the semiconductor patterns SP of the first layer L1, the wordlines WL of the first layer L1 may extend in the first direction D1 to intersect the channel regions CH of the semiconductor patterns SP of the first layer L1.

In some embodiments, the memory cell transistors MCT may be gate-all-around (GAA) transistors, where the wordlines WL surround the channel regions CH. The wordlines WL may surround the perimeter surfaces of the channel regions CH. The wordlines WL may extend in the first direction D1 and surround the channel regions CH of the semiconductor patterns SP that are at the same vertical level (i.e. in the direction D3). The semiconductor patterns SP may be spaced apart from each other in the first direction D1.

The wordlines WL may include a conductive material. In example embodiments, the wordlines WL may include at least one of a doped semiconductor material (e.g., doped silicon, doped silicon-germanium, doped germanium, etc.), a conductive metal nitride (e.g., titanium nitride, tantalum nitride, etc.), a metal (e.g., tungsten (W), titanium (Ti), tantalum (Ta), etc.), or a metal-semiconductor compound (e.g., tungsten silicide, cobalt silicide, titanium silicide, etc.), but the present disclosure is not limited thereto.

A plurality of bitlines BL extending in a vertical direction (i.e., in the third direction D3) may be provided on the substrate 100. Each of the bitlines BL may have a linear or pillar shape extending in the third direction D3. The bitlines BL may be arranged along the first direction D1. The bitlines BL may be electrically connected to the first impurity regions SD1 of the semiconductor patterns SP that are vertically stacked.

The bitlines BL may include a conductive material. For example, the bitlines BL may include at least one of a doped semiconductor material, a conductive metal nitride, a metal, or a metal-semiconductor compound, but the present disclosure is not limited thereto.

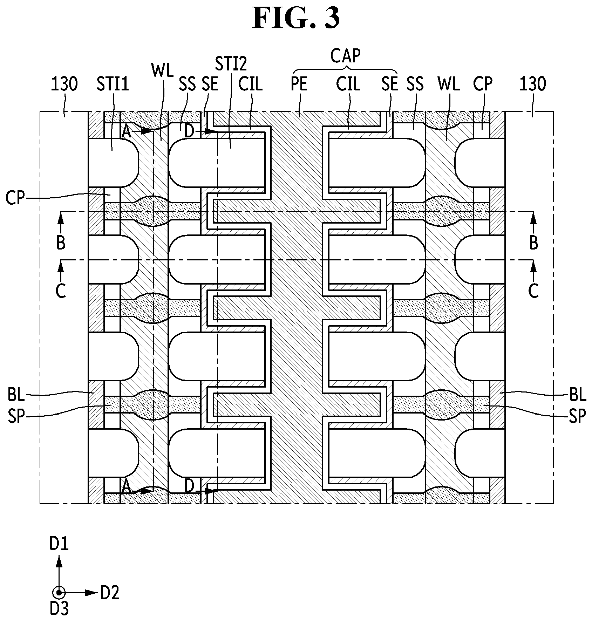

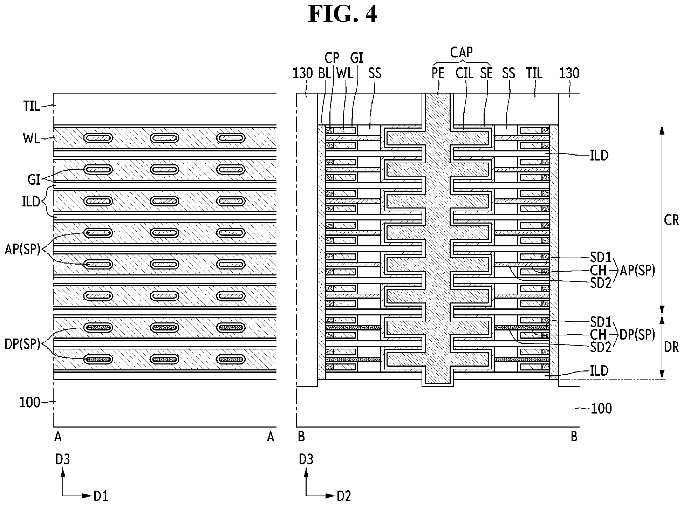

FIG. 3 is a plan view for a semiconductor memory device according to some embodiments. FIG. 4 includes cross-sectional views taken along lines A-A and B-B of FIG. 3.

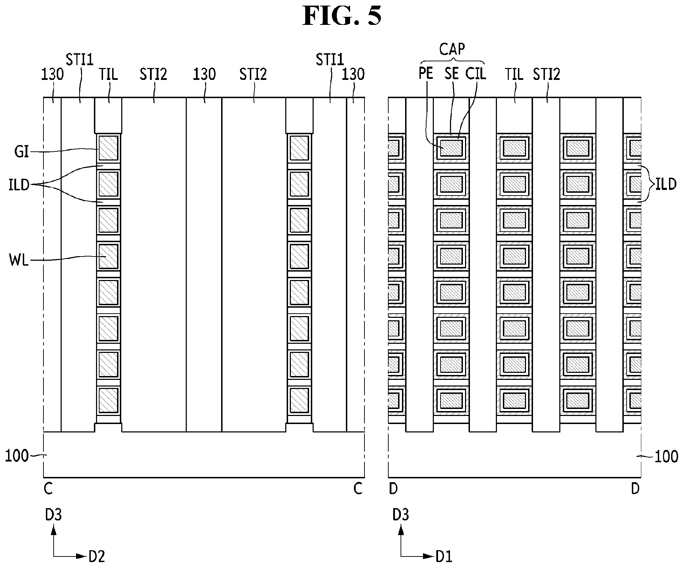

FIG. 5 includes cross-sectional views taken along lines C-C and D-D of FIG. 3. For convenience, overlapping content with FIGS. 1-2 will be briefly described, with a focus on the differences.

Referring to FIGS. 3-5, the semiconductor memory device according to some embodiments may include a substrate 100, a plurality of interlayer insulating patterns ILD, a plurality of semiconductor patterns SP, bitlines BL, wordlines WL, gate insulating films GI, capping insulating patterns CP, spacer insulating patterns SS, first isolation insulating patterns STI1, second isolation insulating patterns STI2, buried insulating patterns 130, and capacitors CAP.

The interlayer insulating patterns ILD may be on the substrate 100. The interlayer insulating patterns ILD may be spaced apart from each other in a third direction D3.

The interlayer insulating patterns ILD may include an insulating material. The interlayer insulating patterns ILD may each include, for example, at least one of a silicon oxide film, a silicon nitride film, a silicon oxynitride film, a carbon (C)-containing silicon oxide film, a C-containing silicon nitride film, or a C-containing silicon oxynitride film. For example, the interlayer insulating patterns ILD may each include a silicon oxide film.

The semiconductor patterns SP may be on the substrate 100. The semiconductor patterns SP may be between the adjacent interlayer insulating patterns ILD in the third direction D3. The semiconductor patterns SP may be spaced apart from each other in the third direction D3. The semiconductor patterns SP may be spaced apart from each other in the third direction D3 on the substrate 100. The interlayer insulating patterns ILD may be between the adjacent semiconductor patterns SP in the third direction D3.

The semiconductor patterns SP may extend in a second direction D2. In the cross-sectional view B-B of FIG. 4, the interlayer insulating patterns ILD may protrude in the second direction D2 beyond the semiconductor patterns SP. First impurity regions SD1 of the semiconductor patterns SP may be connected to the bitlines BL. Second impurity regions SD2 of the semiconductor patterns SP may be connected to storage electrodes SE.

The semiconductor memory device according to some embodiments may include a dummy region DR and a cell region CR. The semiconductor patterns SP may include one or more dummy patterns DP in the dummy region DR and a plurality of active patterns AP in the cell region CR. The cell region CR may include a plurality of interlayer insulating patterns ILD and a plurality of active patterns AP that are alternately stacked. The cell region CR is a region which may include cell transistors (e.g., the memory cell transistors MCT of FIG. 1) of the semiconductor memory device according to some embodiments, and the dummy region DR is a region which may include dummy patterns DP of the semiconductor memory device according to some embodiments.

The dummy patterns DP may include a tensile stress material. The dummy patterns DP may include Si and a first element (e.g., C or boron (B)) having a smaller atomic size than Si. In example embodiments, the dummy patterns DP may include SiC.

The active patterns AP may include Si. In some embodiments, the active patterns AP may not include C. In some embodiments, the dummy region DR may be between the substrate 100 and the cell region CR. The dummy region DR may be below the cell region CR.

In some embodiments, the dummy region DR may include a plurality of dummy patterns DP. The dummy region DR may include a plurality of interlayer insulating patterns ILD and a plurality of dummy patterns DP that are alternately stacked.

The bitlines BL may extend in the third direction D3 on the substrate 100. The bitlines BL may be on the semiconductor patterns SP and on the interlayer insulating patterns ILD. The bitlines BL may be connected to the semiconductor patterns SP that are spaced apart in the third direction D3.

In some embodiments, the wordlines WL may be between the adjacent interlayer insulating patterns ILD in the third direction D3. The wordlines WL may intersect the semiconductor patterns SP. The wordlines WL may extend along the circumference or perimeter of the semiconductor patterns SP.

The wordlines WL on the dummy patterns DP may be dummy wordlines. No voltage may be applied to the dummy wordlines, and the dummy wordlines may be electrically floated.

The gate insulating films GI may be between the wordlines WL and the semiconductor patterns SP, and between the wordlines WL and the interlayer insulating patterns ILD. The gate insulating films GI may extend along the upper surfaces and lower surfaces of the wordlines WL and along first sidewalls of the wordlines WL that extend in the third direction D3 and are adjacent to the spacer insulating patterns SS.

The gate insulating films GI may include, in example embodiments, at least one of a high-k insulating film, a silicon oxide film, a silicon nitride film, or a silicon oxynitride film. A "high-k" material may be a material that has a dielectric constant that is greater than that of silicon oxide.

The capping insulating patterns CP may be between the first impurity regions SD1 of the semiconductor patterns SP and the interlayer insulating patterns ILD. The capping insulating patterns CP may be on the upper surfaces and lower surfaces of the semiconductor patterns SP. The capping insulating patterns CP may spatially separate the bitlines BL and the wordlines WL. The gate insulating films GI may be interposed between the capping insulating patterns CP and the interlayer insulating patterns ILD, and between the capping insulating patterns CP and the semiconductor patterns SP.

The spacer insulating patterns SS may be between the second impurity regions SD2 of the semiconductor patterns SP and the interlayer insulating patterns ILD. The spacer insulating patterns SS may be on the upper surfaces and lower surfaces of the semiconductor patterns SP. The spacer insulating patterns SS may be spaced apart from the wordlines WL with the gate insulating films GI in between. The gate insulating films GI may be interposed between the spacer insulating patterns SS and the interlayer insulating patterns ILD, and between the spacer insulating patterns SS and the semiconductor patterns SP.

The capping insulating patterns CP and the spacer insulating patterns SS may each include, in example embodiments, at least one of a silicon oxide film, a silicon nitride film, a silicon oxynitride film, a C-containing silicon oxide film, a C-containing silicon nitride film, or a C-containing silicon oxynitride film.

The first isolation insulating patterns STI1 and the second isolation insulating patterns STI2 may be on the substrate 100. The first isolation insulating patterns STI1 and the second isolation insulating patterns STI2 may be between the adjacent bitlines BL and the adjacent storage electrodes SE in the first direction D1.

The buried insulating patterns 130 may be on the substrate 100. The buried insulating patterns 130 may cover the sidewalls of the bitlines BL and the sidewalls of the first isolation insulating patterns STI1.

The first isolation insulating patterns STI1, the second isolation insulating patterns STI2, and the buried insulating patterns 130 may each be formed of at least one insulating material formed using a spin-on-glass (SOG) technique, silicon oxide, or silicon oxynitride.

In some embodiments, the data storage devices DS of FIG. 2 may include capacitors CAP. The capacitors CAP may be adjacent to the semiconductor patterns SP and on the interlayer insulating patterns ILD. The capacitors CAP and the bitlines BL may be at opposite ends, in the second direction D2, of the semiconductor patterns SP. The capacitors CAP may include capacitor dielectric films CIL, the storage electrodes SE, and plate electrodes PE. The capacitors CAP may include storage electrodes SE, capacitor dielectric films CIL, and plate electrodes PE that are respectively interposed between the interlayer insulating patterns ILD. The perimeter of the capacitors CAP may be defined by the respective storage electrodes SE.

The storage electrodes SE may be between the adjacent interlayer insulating patterns ILD in the third direction D3. The storage electrodes SE included in the capacitors CAP may be separated from each other. The adjacent storage electrodes SE in the third direction D3 may be separated by the interlayer insulating patterns ILD. The storage electrodes SE may extend along the upper surfaces and lower surfaces of the interlayer insulating patterns ILD, the side surfaces of the semiconductor patterns SP, and the side surfaces of the spacer insulating patterns SS. The storage electrodes SE may not extend along the side surfaces of the interlayer insulating patterns ILD.

The capacitor dielectric films CIL may be on the storage electrodes SE and the interlayer insulating patterns ILD. The capacitor dielectric films CIL may extend along the profiles of the storage electrodes SE and the side surfaces of the interlayer insulating patterns ILD. The plate electrodes PE may be on the capacitor dielectric films CIL. The capacitor dielectric films CIL and the plate electrodes PE may be sequentially on the storage electrodes SE.

The capacitor dielectric films CIL and the plate electrodes PE included in the capacitors CAP may be electrically and/or spatially connected to each other.

The storage electrodes SE and the plate electrodes PE may each include, in example embodiments, at least one of a doped semiconductor material, a conductive metal nitride (e.g., titanium nitride, tantalum nitride, niobium nitride, or tungsten nitride), a metal (e.g., ruthenium, iridium, titanium, niobium, tungsten, cobalt, molybdenum, or tantalum), or a conductive metal oxide (e.g., iridium oxide or niobium oxide), but the present disclosure is not limited thereto. In example embodiments, the storage electrodes SE may include a conductive metal nitride, a metal, and a conductive metal oxide. The conductive metal nitride, metal, and conductive metal oxide may be included in a metallic conductive film.

The capacitor dielectric films CIL may include, in example embodiments, a high-k material (e.g., hafnium oxide, hafnium silicon oxide, lanthanum oxide, zirconium oxide, zirconium silicon oxide, tantalum oxide, titanium oxide, barium strontium titanate, barium titanate, strontium titanate, lithium oxide, aluminum oxide, lead scandium tantalate, lead zinc niobate, or a combination thereof). In some embodiments, the capacitor dielectric films CIL may include a stack film structure in which zirconium oxide, aluminum oxide, and zirconium oxide are sequentially stacked. In some embodiments, the capacitor dielectric films CIL may include hafnium (Hf).

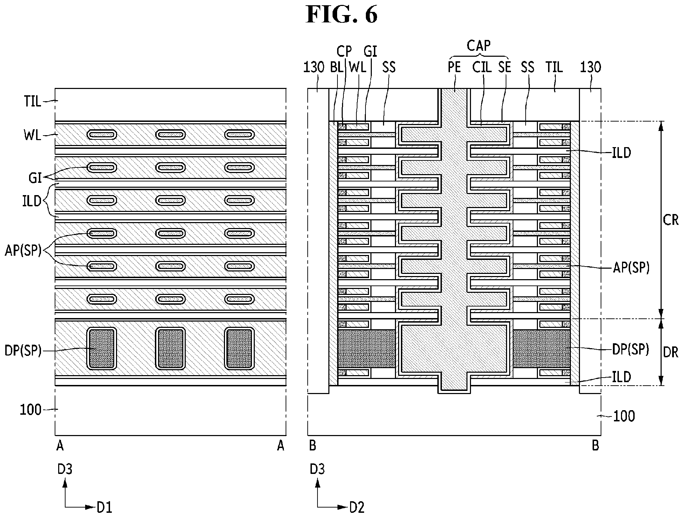

FIGS. 6-12 are diagrams of semiconductor memory devices according to some embodiments. For reference, FIGS. 6-12 are cross-sectional views taken along lines A-A and B-B of FIG. 3. For convenience, overlapping content with FIGS. 1-5 will be briefly described, with a focus on the differences.

Referring to FIG. 6, a dummy region DR may include one dummy pattern DP. The thickness, in a third direction D3, of the dummy pattern DP may be greater than the thickness, in the third direction D3, of active patterns AP (e.g. of each active pattern AP).

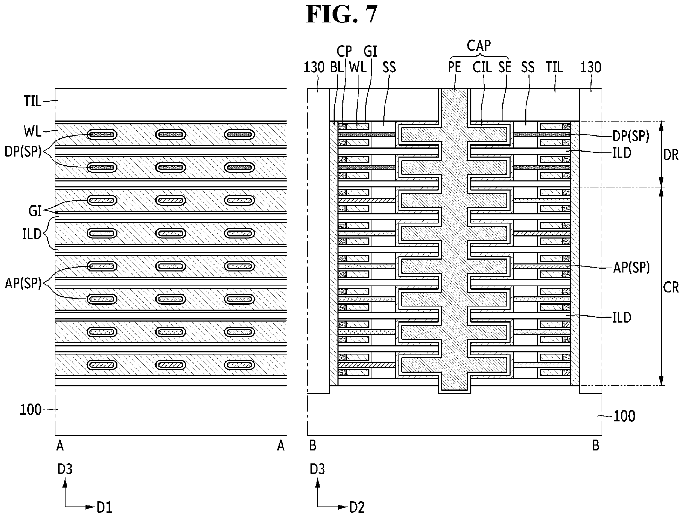

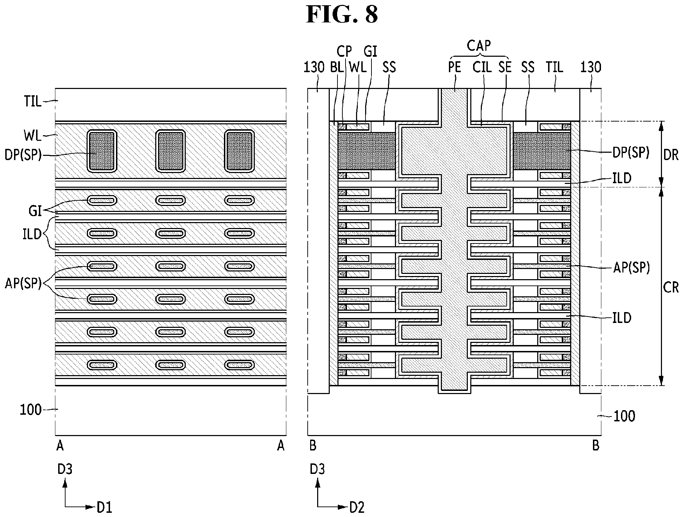

Referring to FIGS. 7 and 8, a cell region CR may be between a substrate 100 and a dummy region DR. The dummy region DR may be above the cell region CR.

Referring to FIG. 7, in some embodiments, the dummy region DR may include a plurality of dummy patterns DP.

Referring to FIG. 8, in some embodiments, the dummy region DR may include one dummy pattern DP. The cell region CR may be between the substrate 100 and the dummy region DR. The thickness, in a third direction D3, of the dummy pattern DP may be greater than the thickness, in the third direction D3, of active patterns AP (e.g. of each active pattern AP).

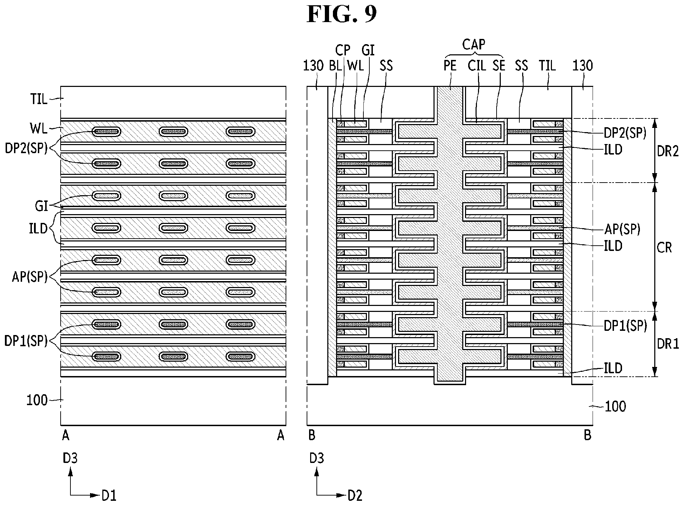

Referring to FIGS. 9-12, the semiconductor memory devices according to some embodiments may each include a first dummy region DR1, a second dummy region DR2, and a cell region CR. The first dummy region DR1 may be below the cell region CR, and the second dummy region DR2 may be above the cell region CR. The cell region CR may be between the first and second dummy regions DR1 and DR2, respectively. The thickness, in a third direction D3, of the first dummy region DR1 may be the same or different from the thickness, in the third direction D3, of the second dummy region DR2.

Semiconductor patterns SP may include at least one first dummy pattern DP1 in the first dummy region DR1, a plurality of active patterns AP in the cell region CR, and at least one second dummy pattern DP2 in the second dummy region DR2.

In some embodiments, the first and second dummy patterns DP1 and DP2, respectively, may include a first element (e.g., C or B) with a smaller atomic size than Si. The average concentration of the first element in the first dummy pattern DP1 may be the same or different from the average concentration of the first element in the second dummy pattern DP2.

In some embodiments, the first and second dummy patterns DP1 and DP2 may include different first and second elements, respectively, each with a smaller atomic size than Si. In example embodiments, one of the first or second dummy patterns (e.g. DP1 or DP2) may include C, while the other dummy pattern (e.g. DP1 or DP2) may include B.

Referring to FIG. 9, in some embodiments, the first dummy region DR1 may include a plurality of first dummy patterns DP1. The first dummy region DR1 may include a plurality of interlayer insulating patterns ILD and a plurality of first dummy patterns DP1 that are alternately stacked. The second dummy region DR2 may include a plurality of second dummy patterns DP2. The second dummy region DR2 may include a plurality of interlayer insulating patterns ILD and a plurality of second dummy patterns DP2 that are alternately stacked.

The number of first dummy patterns DP1 and the number of second dummy patterns DP2 may be the same or different.

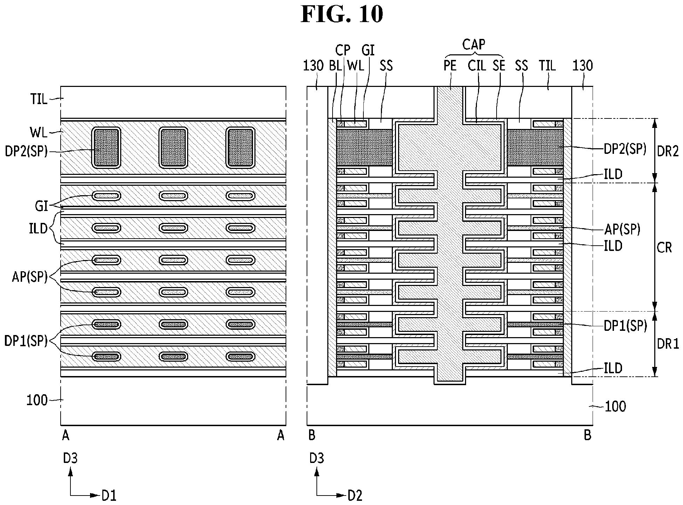

Referring to FIG. 10, in some embodiments, the first dummy region DR1 may include a plurality of first dummy patterns DP1, and the second dummy region DR2 may include one second dummy pattern DP2. The thickness, in the third direction D3, of the first dummy patterns DP1 may be smaller than or different from the thickness, in the third direction D3, of the second dummy pattern DP2.

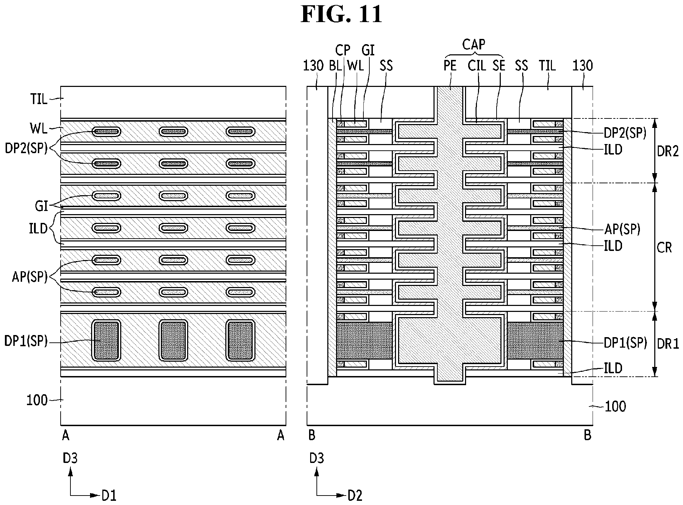

Referring to FIG. 11, in some embodiments, the first dummy region DR1 may include one first dummy pattern DP1, and the second dummy region DR2 may include a plurality of second dummy patterns DP2. The thickness, in the third direction D3, of the second dummy patterns DP2 may be smaller than or different from the thickness, in the third direction D3, of the first dummy pattern DP1.

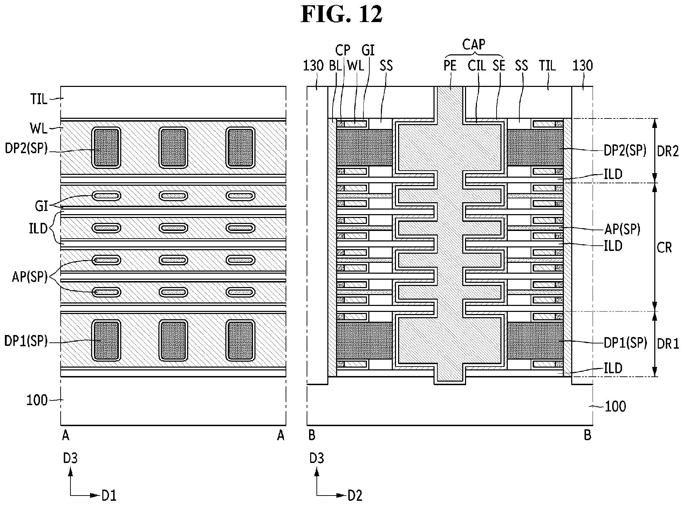

Referring to FIG. 12, in some embodiments, the first dummy region DR1 may include one first dummy pattern DP1, and the second dummy region DR2 may include one second dummy pattern DP2. The thickness, in the third direction D3, of the first dummy pattern DP1 may be the same as the thickness, in the third direction D3, of the second dummy pattern DP2.

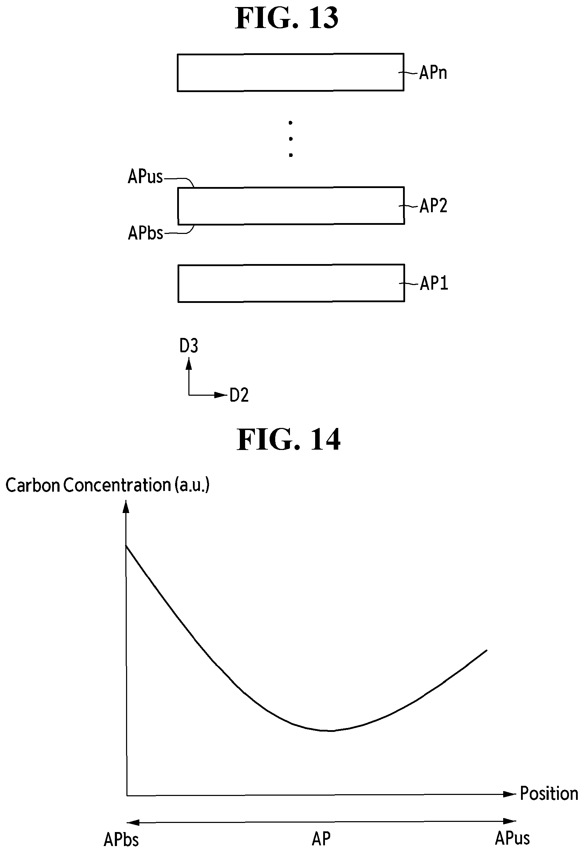

FIGS. 13 is a diagram of the active patterns AP and semiconductor patterns SP of FIGS. 3-4 and FIGS.6-12. FIG. 14 is a graphical representation of the concentration of C within the active patterns AP according to example embodiments.

Referring to FIG. 4 and FIGS. 6-13, the active patterns AP may include first-n-th active patterns AP1 through APn (where n is a natural number greater than or equal to 2). The first active pattern AP1 may be the closest active pattern AP to the substrate 100, and the n-th active pattern APn may be the farthest active pattern from the substrate 100.

In some embodiments, the active patterns AP may include Si and C. In some embodiments, the average concentrations of C in the active patterns AP may differ. The average concentration of C in the first active pattern AP1 may be greater than the average concentration of C in the n-th active pattern APn. The closer the active patterns AP are to the substrate 100, the higher the average concentration of C in the active patterns AP may be.

Referring to FIGS. 3-14, each of the active patterns AP may include an upper surface APus (e.g. second surface) and a lower surface APbs (e.g. first surface) that are opposite to each other in the third direction D3. The lower surfaces APbs may face the substrate 100. The upper surfaces APus may face away from the substrate 100.

In some embodiments, the active patterns AP may include Si and C. In some embodiments, the concentration of C at the lower surfaces APbs of the active patterns AP may differ from the concentration of C at the upper surfaces APus of the active patterns AP. The concentration of C at the lower surfaces APbs of the active patterns AP may be greater than the concentration of C at the upper surfaces APus of the active patterns AP. The concentration of C in the active patterns AP may decrease and then increase along the direction from the lower surfaces APbs to the upper surfaces APus.

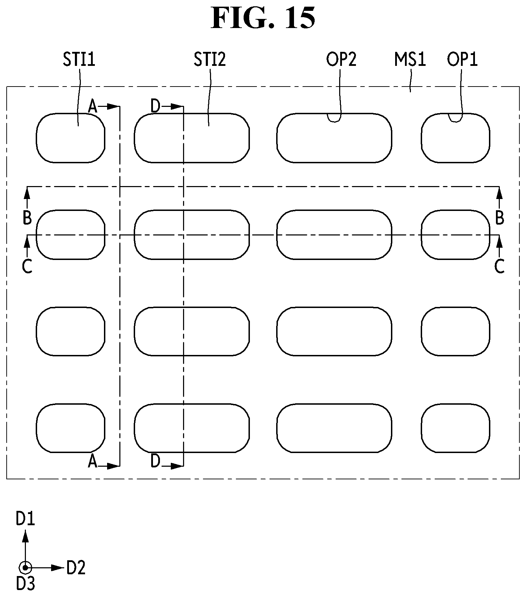

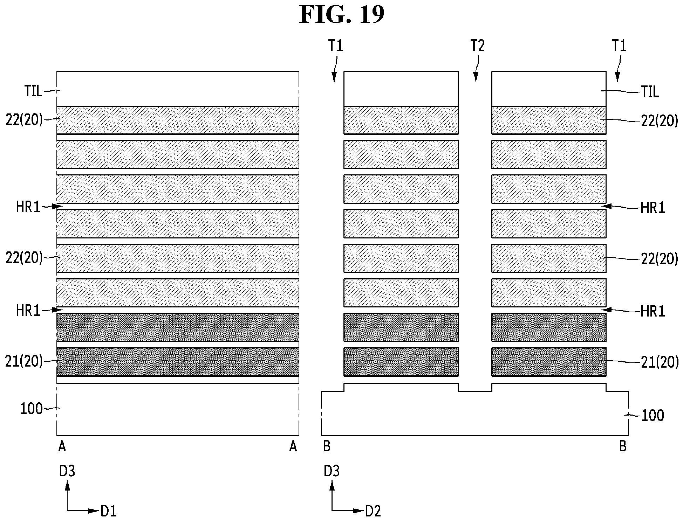

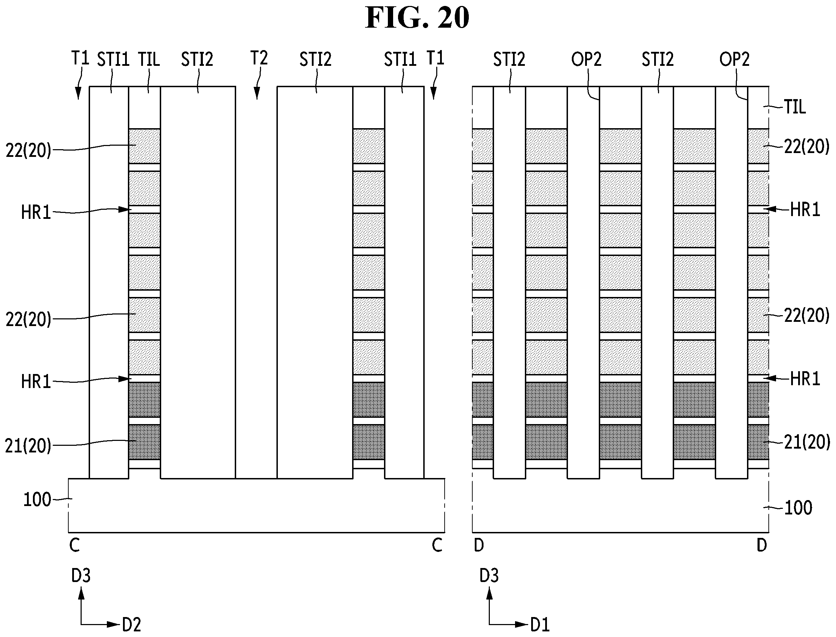

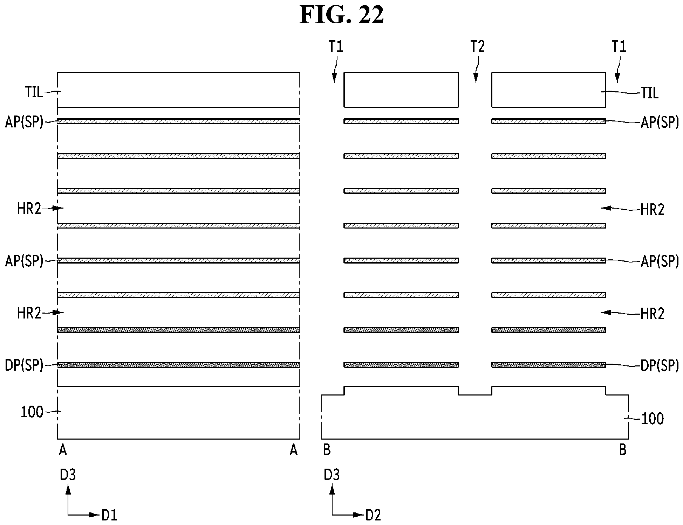

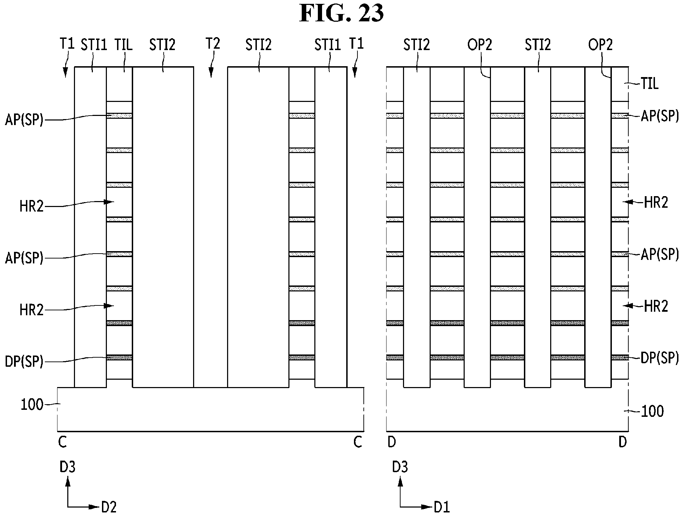

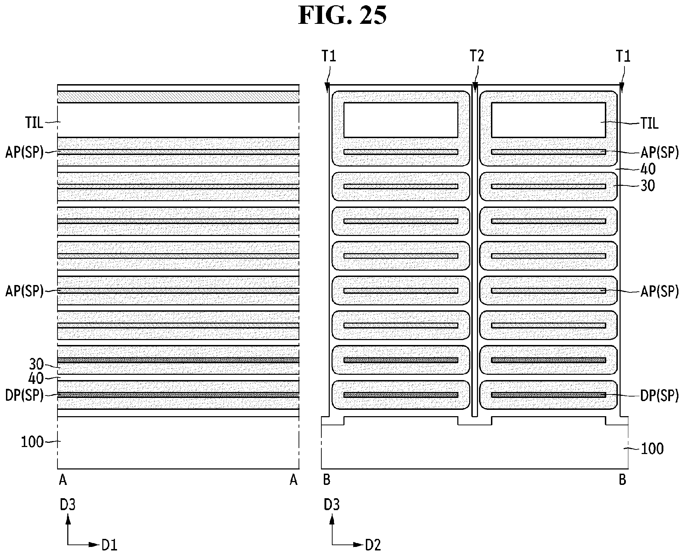

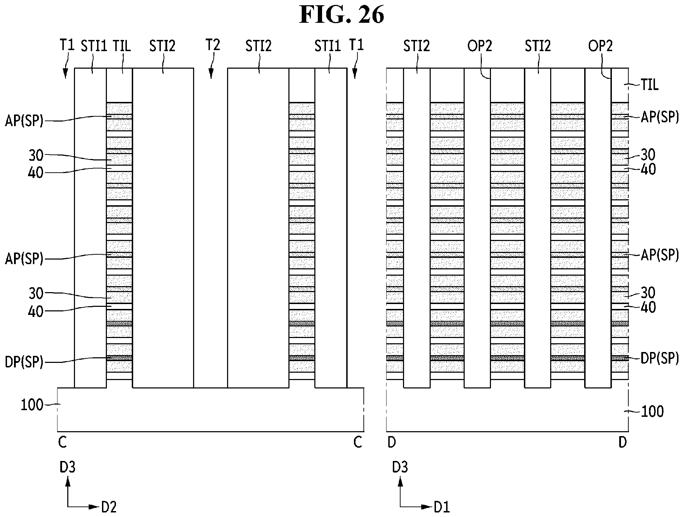

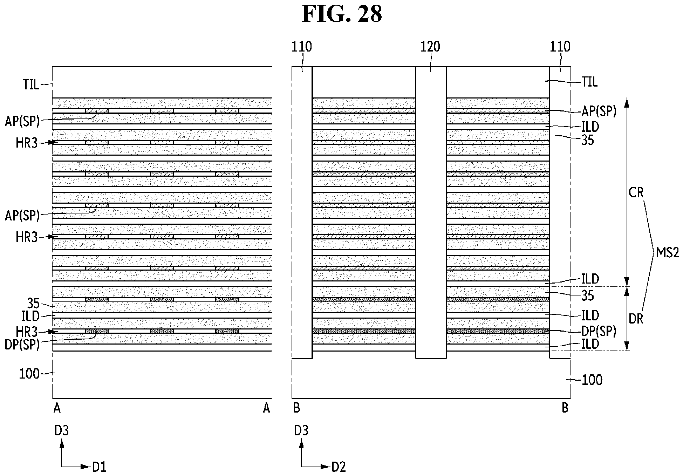

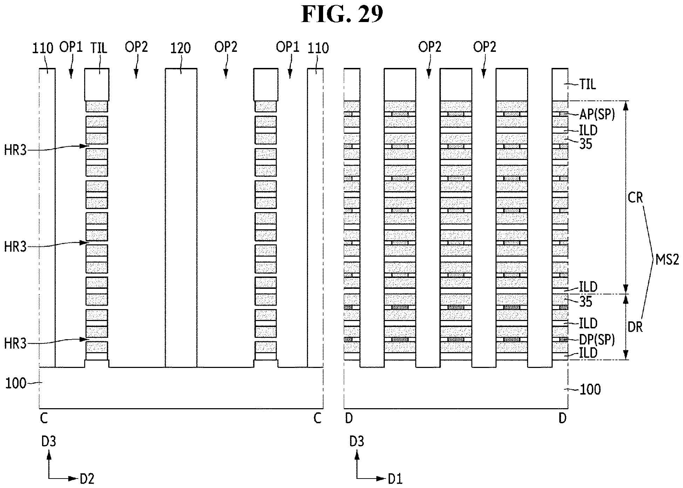

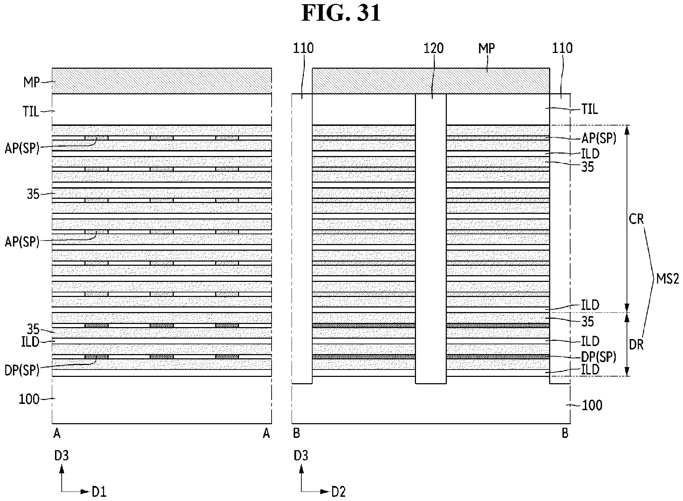

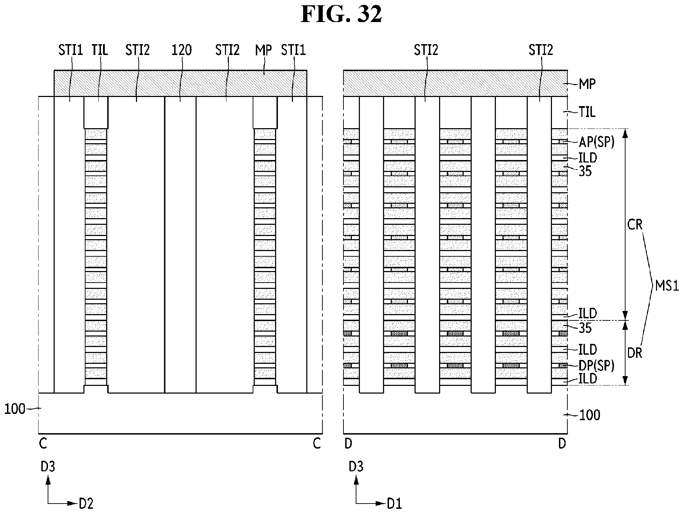

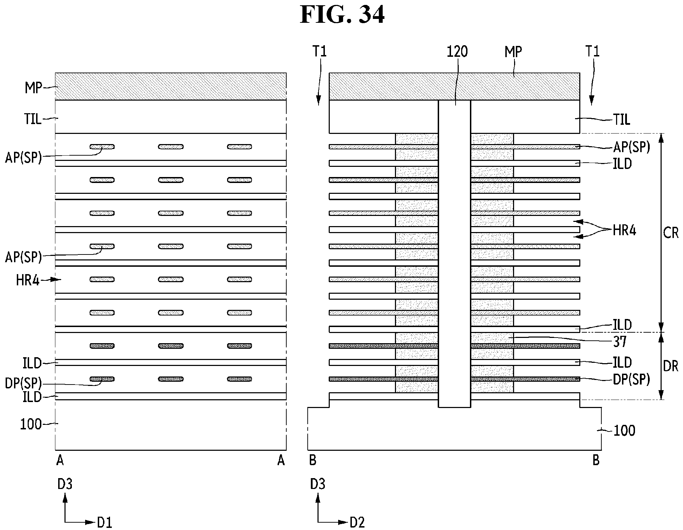

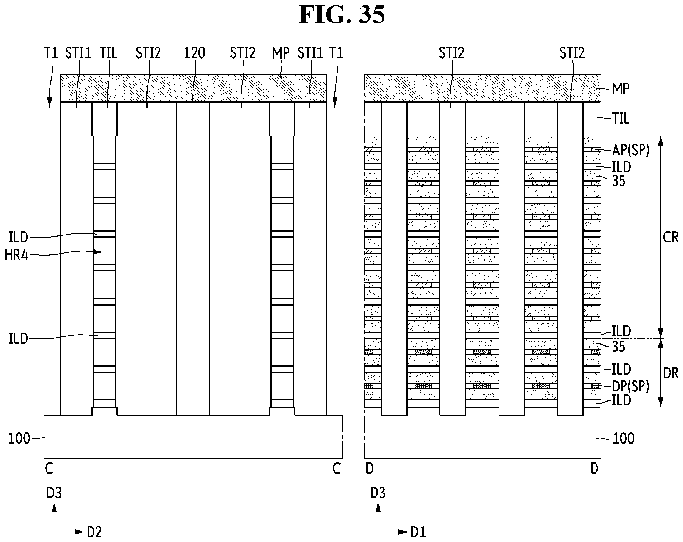

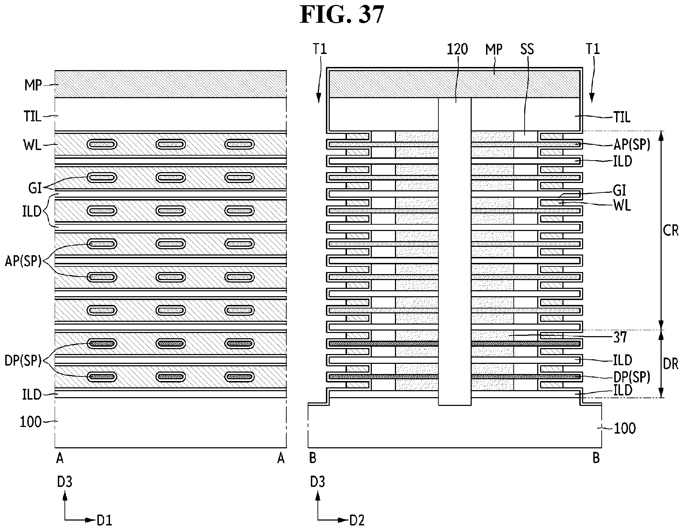

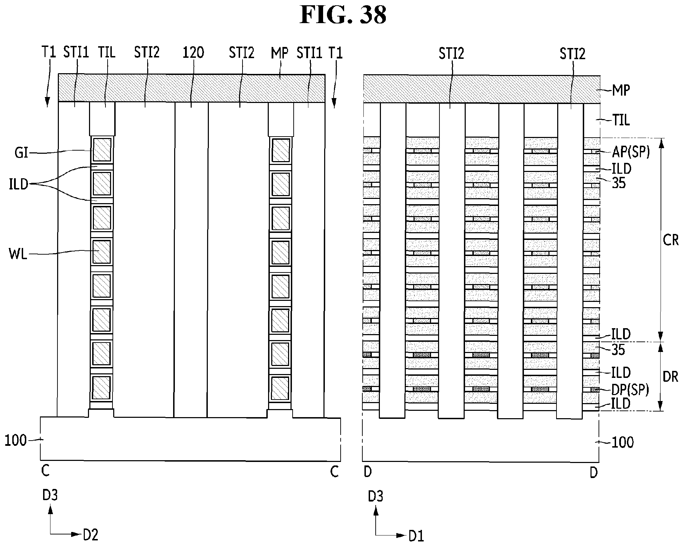

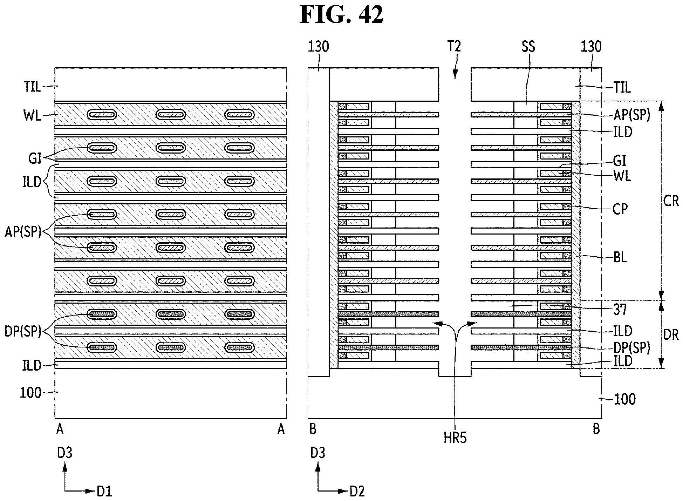

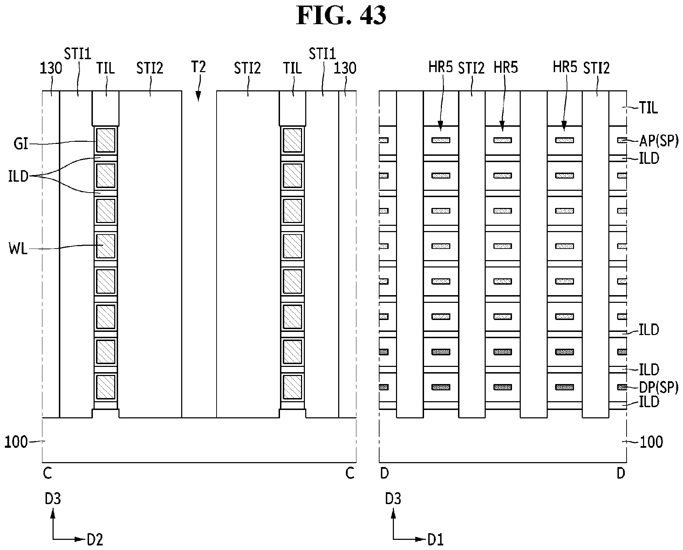

FIGS. 15-43 are diagrams for a method of fabricating a semiconductor device according to some embodiments. For convenience, the embodiment of FIGS. 15-43 will hereinafter be described, focusing mainly on the differences from what has been described above with reference to FIGS. 1-14.

Referring to FIGS. 15-17, a first mold structure MS1, including a plurality of first sacrificial films 10 and a plurality of semiconductor layers 20 that are alternately stacked on a substrate 100, may be formed.

The first sacrificial films 10 may be spaced apart from each other in a third direction D3 on the substrate 100. The semiconductor layers 20 may be between the adjacent first sacrificial films 10 in the third direction D3. The semiconductor layers 20 may be spaced apart from each other in the third direction D3 on the substrate 100. The first sacrificial films 10 may be between the adjacent semiconductor layers 20 in the third direction D3. The thickness, in the third direction D3, of the first sacrificial films 10 may be smaller than the thickness, in the third direction D3, of the semiconductor layers 20.

The first sacrificial films 10 may be formed of a material with etch selectivity with respect to the semiconductor layers 20. The first sacrificial films 10 and the semiconductor layers 20 may be formed by performing an epitaxial growth process.

The first mold structure MS1 may include a dummy region DR and a cell region CR. The semiconductor layers 20 may include at least one dummy film 21 in the dummy region DR and a plurality of active films 22 in the cell region CR. The cell region CR may include a plurality of first sacrificial films 10 and a plurality of active films 22 that are alternately stacked.

In some embodiments, the dummy region DR may be between the substrate 100 and the cell region CR.

In some embodiments, the dummy region DR may include a plurality of dummy films 21. The dummy region DR may include a plurality of first sacrificial films 10 and a plurality of dummy films 21 that are alternately stacked.

The first sacrificial films 10 and the dummy films 21 may include materials with stresses in different directions. The first sacrificial films 10 may include a compressive stress material, and the dummy films 21 may include a tensile stress material. A compressive stress material may be a material that is under compressive stress (e.g. biaxial compressive stress) within the structure (e.g. due to lattice mismatch). For instance, a compressive stress material may have a larger lattice constant than an adjacent layer (e.g. a larger lattice constant than that of silicon). A tensile stress material may be a material that is under tensile stress (e.g. biaxial tensile stress) within the structure (e.g. due to lattice mismatch). For instance, a tensile stress material may have a smaller lattice constant than an adjacent layer (e.g. a smaller lattice constant than silicon). The active films 22 may include Si, the first sacrificial films 10 may include an element with a larger atomic size than Si (e.g., Ge), and the dummy films 21 may include an element with a smaller atomic size than Si (e.g., C or B). In example embodiments, the active films 22 may include Si, the first sacrificial films 10 may include a material with a larger lattice constant than Si (e.g., SiGe or SiGeC), and the dummy films 21 may include a material with a smaller lattice constant than Si (e.g., SiC).

In example embodiments, the dummy films 21 may have a thickness of 50-500 nm in the third direction D3, and if the dummy films 21 include SiC, the concentration of C in the dummy films 21 may be 5% or less. The thickness of the dummy films 21 and the concentration of the element (e.g., C or B) in the dummy films 21 may vary depending on the thickness of the first sacrificial films 10, the concentration of Ge in the first sacrificial films 10, and the concentration of C in the first sacrificial films 10.

When the first mold structure MS1 includes the first sacrificial films 10 and the active films 22 that are alternately stacked, the first mold structure MS1 may receive compressive stress because the first sacrificial films 10 may include a compressive stress material, which can cause bending in the first mold structure MS1.

However, the first mold structure MS1 may include dummy films 21 that contain a tensile stress material. Therefore, the bending of the first mold structure MS1 can be offset or mitigated, allowing the formation of a first mold structure MS1 with a greater number of layers. In other words, by adjusting the thickness and material of the dummy films 21, the bending of the first mold structure MS1 can be offset or mitigated. As a result, a semiconductor memory device with a greater number of layers can be formed.

An upper insulating film TIL may be formed on the first mold structure MS1. The upper insulating film TIL may cover the uppermost semiconductor film 20. The upper insulating film TIL may be formed of an insulating material with etch selectivity relative to the first sacrificial films 10 and the semiconductor films 20. In example embodiments, the upper insulating film TIL may be a silicon oxide film.

Thereafter, first openings OP1 and second openings OP2, exposing the substrate 100, may be formed by patterning the upper insulating film TIL and the first mold structure MS1.

The formation of the first openings OP1 and the second openings OP2 may involve forming a mask pattern with openings corresponding to the first openings OP1 and the second openings OP2 on the first mold structure MS1, and performing anisotropic etching on the first mold structure MS1 using the mask pattern as an etch mask.

The first openings OP1 and the second openings OP2 may expose the upper surface of the substrate 100, and during anisotropic etching, over-etching may cause recesses to be formed on the upper surface of the substrate 100 below the first openings OP1 and the second openings OP2.

The first openings OP1 may be formed to be spaced apart from each other along a first direction D1. The second openings OP2 may be formed to be spaced apart from each other along the first direction D1. The second openings OP2 may be spaced apart from the first openings OP1 in a second direction D2. A pair of second openings OP2 may be formed between a pair of first openings OP1. In the first direction D1, the first openings OP1 and the second openings OP2 may be spaced apart from each other by a first interval. In the second direction D2, the first openings OP1 may be spaced apart from the second openings OP2 by a second interval smaller than the first interval. In the first direction D1, the first openings OP1 and the second openings OP2 may have the same width. In the second direction D2, the first openings OP1 may have a first length, and the second openings OP2 may have a second length greater than the first length.

Thereafter, first isolation insulating patterns STI1 and second isolation insulating patterns STI2 may be filled into the first openings OP1 and the second openings OP2, respectively.

The first isolation insulating patterns STI1 and the second isolation insulating patterns STI2 may be in contact with the substrate 100. The first isolation insulating patterns STI1 and the second isolation insulating patterns STI2 may be formed by depositing an isolation insulating film to fill the first openings OP1 and the second openings OP2, and then planarizing the isolation insulating film to expose the upper surface of the upper insulating film TIL.

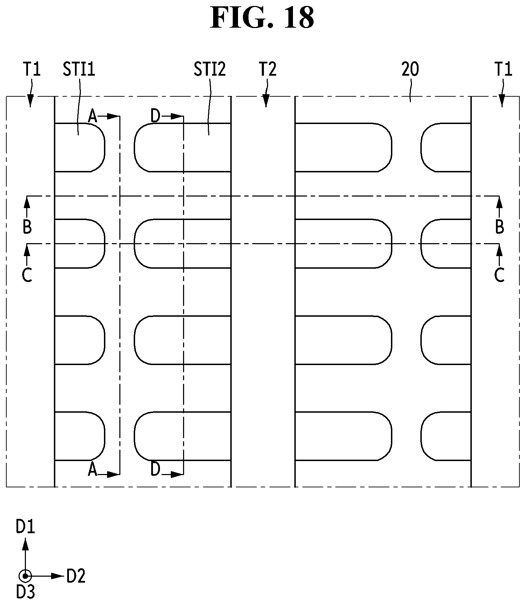

Referring to FIGS. 18-20, a plurality of first trenches T1 and a second trench T2, which expose the sidewalls of the first sacrificial films 10 and the semiconductor films 20 through the first mold structure MS1, may be formed.

The formation of the first trenches T1 and the second trench T2 may involve forming a mask pattern with openings corresponding to the first trenches T1 and the second trench T2 on the first mold structure MS1 and performing anisotropic etching on the first mold structure MS1 using the mask pattern as an etch mask. The first trenches T1 and the second trench T2 may expose the upper surface of the substrate 100, and during anisotropic etching, over-etching may cause recesses to form on the upper surface of the substrate 100 below the first trenches T1 and the second trench T2.

The first trenches T1 and the second trench T2 may extend parallel to each other along the first direction D1. The first trenches T1 and the second trench T2 may expose the sidewalls of the first sacrificial films 10 and the sidewalls of the semiconductor films 20. Additionally, the first trenches T1 may extend along the first direction D1 to expose the sidewalls of the first isolation insulating patterns STI1. The second trench T2 may be formed between a pair of first trenches T1 and may extend along the first direction D1 to expose the sidewalls of the second isolation insulating patterns STI2.

Thereafter, first horizontal regions HR1 may be formed between the adjacent semiconductor films 20 in the third direction D3 by removing the first sacrificial films 10 exposed within the first trenches T1 and the second trench T2.

The formation of the first horizontal regions HR1 may involve isotropically etching the first sacrificial films 10 by performing an isotropic etching process with etch selectivity relative to the substrate 100, the semiconductor films 20, and the first isolation insulating patterns STI1 and the second isolation insulating patterns STI2. When the first sacrificial films 10 are removed, the semiconductor films 20 may remain vertically (e.g. in the third direction D3) spaced apart by the first isolation insulating patterns STI1 and the second isolation insulating patterns STI2.

The thickness, in the third direction D3, of the first horizontal regions HR1 (i.e. the distance between the adjacent semiconductor films 20 in the third direction D3) may be the same as the thickness of the first sacrificial films 10.

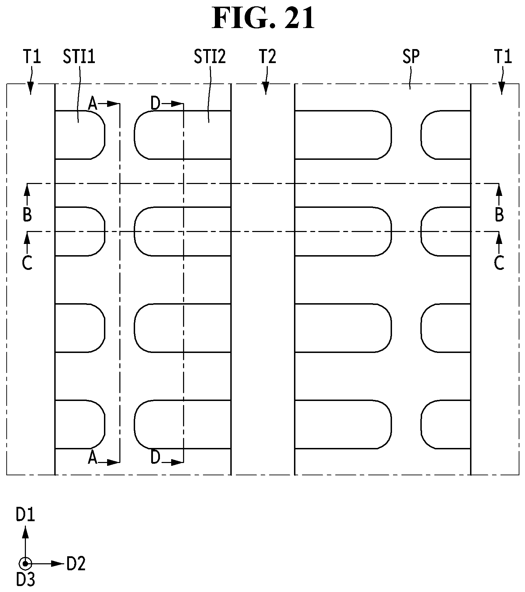

Referring to FIGS. 21-23, an enlargement process may be performed to increase the thickness, in the third direction D3, of the first horizontal regions HR1.

For example, the enlargement process may involve etching the upper surfaces and lower surfaces of the semiconductor films 20 exposed in the first horizontal regions HR1. The enlargement process may involve performing an isotropic etching process with etch selectivity relative to the upper insulating film TIL, the first isolation insulating patterns STI1, and the second isolation insulating patterns STI2. As a result of the enlargement process, the thickness of the semiconductor films 20 may be reduced. Consequently, semiconductor patterns SP may be formed, and second horizontal regions HR2 may be formed between the adjacent semiconductor patterns SP in the third direction D3. The semiconductor patterns SP may include active patterns AP formed by the enlargement process applied to the active films 22, and dummy patterns DP formed by the enlargement process applied to the dummy films 21.

In some embodiments, an oxidation process may be performed on the semiconductor patterns SP, resulting in the formation of sacrificial oxide films on the surfaces of the semiconductor patterns SP. Thereafter, the sacrificial oxide films may be removed, and the surfaces of the semiconductor patterns SP may be re-exposed. The removal of the sacrificial oxide films may increase the distance between the adjacent semiconductor patterns SP in the third direction D3. In other words, the second horizontal regions HR2 may be further expanded in the third direction D3.

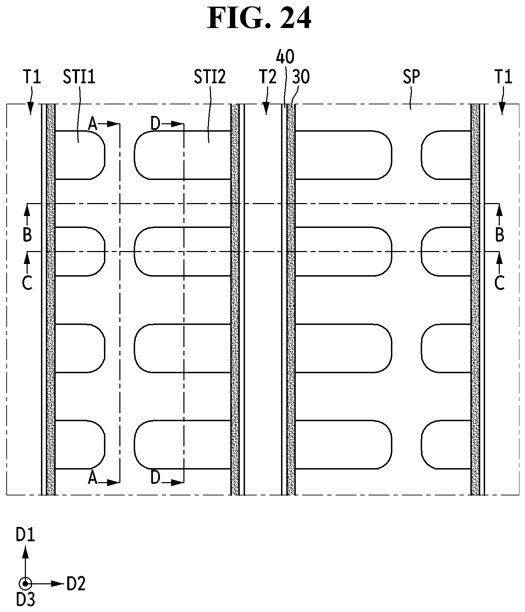

Referring to FIGS. 24-26, second sacrificial films 30 and interlayer insulating films 40 may be sequentially deposited on the surfaces of the semiconductor patterns SP.

The second sacrificial films 30 may be formed by depositing a material with etch selectivity relative to the substrate 100 and the semiconductor patterns SP. In example embodiments, the second sacrificial films 30 may be formed of at least one of silicon oxide, silicon nitride, or silicon oxynitride. The second sacrificial films 30 may be formed by atomic layer deposition (ALD) or chemical vapor deposition (CVD).

The second sacrificial films 30 may be formed to surround the semiconductor patterns SP. The second sacrificial films 30 may be formed to have a thickness smaller than half of the thickness of the second horizontal regions HR2 in the third direction D3. Consequently, after the deposition of the second sacrificial films 30, gap regions may be defined between the adjacent semiconductor patterns SP in the third direction D3.

Thereafter, the interlayer insulating films 40 may be formed on the second sacrificial films 30 to fill the second horizontal regions HR2 where the second sacrificial films 30 have been formed (e.g. to fill the remaining portion of the second horizontal regions HR2). The interlayer insulating films 40 may be formed of an insulating material with etch selectivity relative to the second sacrificial film 30 and the substrate 100. In example embodiments, the interlayer insulating films 40 may be formed of silicon oxide.

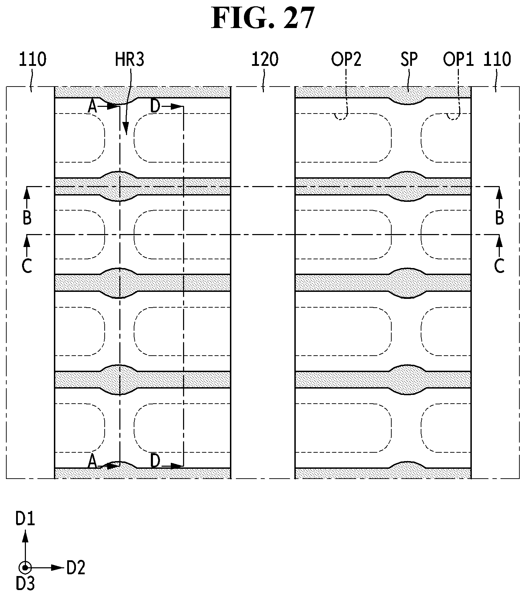

Referring to FIGS. 27-29, a second mold structure MS2 may be formed by sequentially performing partial etching processes on the interlayer insulating films 40 and the second sacrificial films 30.

Specifically, after forming the interlayer insulating films 40, interlayer insulating patterns ILD may be formed by etching parts of the interlayer insulating films 40 exposed in the first trenches T1 and the second trench T2. The interlayer insulating patterns ILD may be formed by isotropically etching the interlayer insulating films 40 until the second sacrificial films 30 are exposed in the first trenches T1 and the second trench T2. The interlayer insulating patterns ILD may have rounded sidewalls as a result of the isotropic etching process. The interlayer insulating patterns ILD may be separated from each other in the third direction D3.

Thereafter, after forming the interlayer insulating patterns ILD, second sacrificial patterns 35 may be formed by etching parts of the second sacrificial films 30 exposed in the first trenches T1 and the second trench T2. The second sacrificial patterns 35 may be formed by isotropically etching the second sacrificial films 30 until the semiconductor patterns SP are exposed. The second sacrificial patterns 35 may have rounded sidewalls as a result of the isotropic etching process. The second sacrificial patterns 35 may be separated from each other in the third direction D3, and a semiconductor pattern SP may be between each pair of adjacent second sacrificial patterns 35 in the third direction D3.

Accordingly, a second mold structure MS2 including the interlayer insulating patterns ILD, the second sacrificial patterns 35, and the semiconductor patterns SP may be formed. The second mold structure MS2 may include a plurality of stack structures including the interlayer insulating patterns ILD, the second sacrificial patterns 35, the semiconductor patterns SP, , and the second sacrificial patterns 35 that are sequentially stacked. The second mold structure MS2 may include a dummy region DR and a cell region CR. The semiconductor patterns SP may include one or more dummy patterns DP in the dummy region DR and a plurality of active patterns AP in the cell region CR.

After forming the second mold structure MS2, first buried insulating patterns 110 and a second buried insulating pattern 120 that fill the first trenches T1 and the second trench T2 may be formed.

The formation of the first buried insulating patterns 110 and the second buried insulating pattern 120 may involve forming a buried insulating film that fills the first trenches T1 and the second trench T2, and then planarizing the buried insulating film to expose the upper surface of the upper insulating film TIL. The planarization of the buried insulating film may be performed using a planarization technique such as a chemical-mechanical polishing (CMP) or etch-back technique.

The first buried insulating patterns 110 and the second buried insulating pattern 120 may be formed of an insulating material with etch selectivity relative to the first isolation insulating patterns STI1 and the second isolation insulating patterns STI2. In example embodiments, the first buried insulating patterns 110 and the second buried insulating pattern 120 may be formed of at least one of silicon oxide, silicon nitride, or silicon oxynitride. The first buried insulating patterns 110 and the second buried insulating pattern 120 may be formed as single-layer films or multilayer films.

After forming the first buried insulating patterns 110 and the second buried insulating pattern 120, the first isolation insulating patterns STI1 and the second isolation insulating patterns STI2 may be removed, thereby re-forming the first openings OP1 and the second openings OP2. The first openings OP1 and the second openings OP2 may expose the sidewalls of the semiconductor patterns SP, the sidewalls of the second sacrificial patterns 35, the sidewalls of the interlayer insulating patterns ILD, and part of the upper surface of the substrate 100.

The removal of the first isolation insulating patterns STI1 and the second isolation insulating patterns STI2 may involve performing an etching process with etch selectivity relative to the substrate 100, the second sacrificial patterns 35, the semiconductor patterns SP, the first buried insulating patterns 110, and the second buried insulating pattern 120. In example embodiments, when the first isolation insulating patterns STI1 and the second isolation insulating patterns STI2 include silicon oxide, a dry etching, chemical etching, or wet etching process may be performed. In example embodiments, during the wet etching process for the first isolation insulating patterns STI1 and the second isolation insulating patterns STI2, a buffered oxide etchant (BOE) or hydrogen fluoride (HF) may be used. During the dry etching process for the first isolation insulating patterns STI1 and the second isolation insulating patterns STI2, CF₄, NH₃, CHF₃, C₂F₆, or BF₃ may be used.

An etching process may be performed on parts of the semiconductor patterns SP exposed in the first openings OP1 and the second openings OP2. As a result, the semiconductor patterns SP may be separated from each other in the first direction D1.

An isotropic etching process may be performed on the semiconductor patterns SP exposed in the first openings OP1 and the second openings OP2. In other words, an etchant may be supplied through the first openings OP1 and the second openings OP2 so that the semiconductor patterns SP may be laterally etched along the first and second directions D1 and D2. At this time, since the distance between the first openings OP1 and the distance between the second openings OP2 are greater than the distance between the first openings OP1 and the second openings OP2, semiconductor patterns SP that are separated in the first direction D1 may be formed. As a result of the isotropic etching process, the width, in the first direction D1, of the semiconductor patterns SP may be greater in the middle than at the sidewalls of the semiconductor patterns SP.

As the semiconductor patterns SP are formed in this manner, third horizontal regions HR3, which expose the sidewalls of the semiconductor patterns SP between the second sacrificial patterns 35, may be formed. The third horizontal regions HR3 may correspond to the areas where the semiconductor patterns SP have been etched.

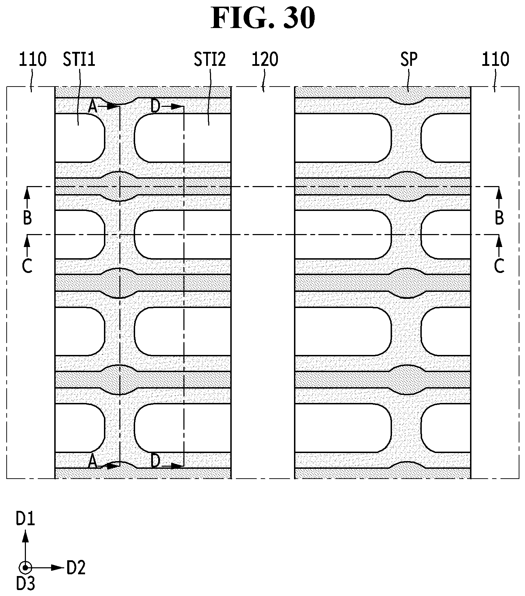

Referring to FIGS. 30-32, after forming the semiconductor patterns SP, the first isolation insulating patterns STI1 and the second isolation insulating patterns STI2 may be re-formed by filling the first openings OP1 and the second openings OP2 again with an insulating material.

The first isolation insulating patterns STI1 and the second isolation insulating patterns STI2 may be formed of an insulating material with etch selectivity relative to the second sacrificial patterns 35 and the interlayer insulating patterns ILD. The first isolation insulating patterns STI1 and the second isolation insulating patterns STI2 may be formed of, in example embodiments, at least one of silicon oxide, silicon oxynitride, or silicon nitride. The first isolation insulating patterns STI1 and the second isolation insulating patterns STI2 may be formed as single-layer films or multilayer films.

The formation of the first isolation insulating patterns STI1 and the second isolation insulating patterns STI2 may involve forming an insulating film that fills the first openings OP1 and the second openings OP2, and then planarizing the insulating film to expose the upper surface of the upper insulating film TIL. The planarization of the insulating film may be performed using a planarization technique such as a chemical-mechanical polishing (CMP) or etch-back technique. The insulating film that fills the first openings OP1 and the second openings OP2 may be formed using an ALD process, a CVD process, or an SOG process.

During the formation of the first isolation insulating patterns STI1 and the second isolation insulating patterns STI2, the third horizontal regions HR3 may be filled with an insulating material or may remain as empty spaces.

After re-forming the first isolation insulating patterns STI1 and the second isolation insulating patterns STI2, a mask pattern MP that exposes the first buried insulating patterns 110 on the upper insulating film TIL may be formed.

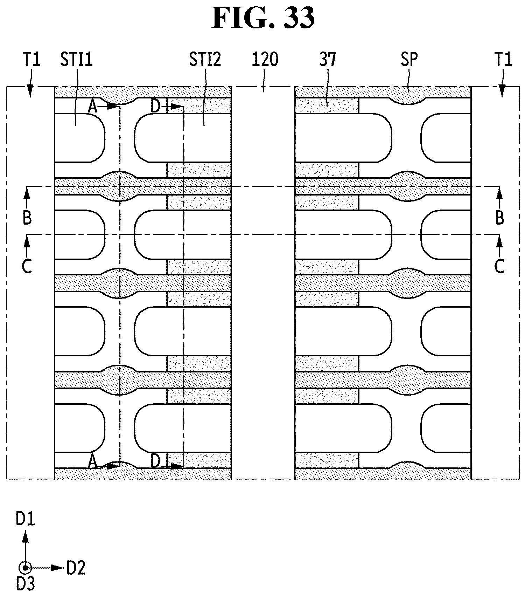

Referring to FIGS. 33-35, first trenches T1 that expose the substrate 100 may be re-formed by etching the first buried insulating patterns 110 using the mask pattern MP as an etch mask. Here, the first trenches T1 may expose the sidewalls of the semiconductor patterns SP, the sidewalls of the second sacrificial patterns 35, and the sidewalls of the interlayer insulating patterns ILD.

Thereafter, fourth horizontal regions HR4 may be formed between the semiconductor patterns SP and the interlayer insulating patterns ILD by removing parts of the second sacrificial patterns 35 exposed within the first trenches T1.

The fourth horizontal regions HR4 may be formed by isotropically etching the second sacrificial patterns 35 using an etching recipe with etch selectivity relative to the semiconductor patterns SP and the interlayer insulating patterns ILD. For example, if the second sacrificial patterns 35 are formed of silicon nitride and the interlayer insulating patterns ILD are formed of silicon oxide, the fourth horizontal regions HR4 may be formed by isotropically etching the second sacrificial patterns 35 using an etchant containing phosphoric acid. The fourth horizontal regions HR4 may extend in the first direction D1 between the first isolation insulating patterns STI1 and the second isolation insulating patterns STI2.

As the fourth horizontal regions HR4 are formed, parts of the second sacrificial patterns 35 may remain, resulting in the formation of third sacrificial patterns 37. The third sacrificial patterns 37 may be separated from each other in the first direction D1 by the second isolation insulating patterns STI2.

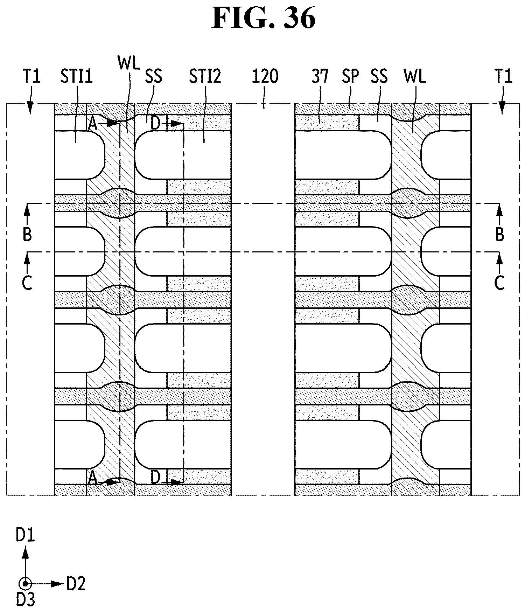

Referring to FIGS. 36-38, spacer insulating patterns SS that fill parts of the fourth horizontal regions HR4 may be formed. The formation of the spacer insulating patterns SS may involve depositing an insulating film to fill the fourth horizontal regions HR4 and then partially etching the insulating film to leave behind portions of the insulating film. The spacer insulating patterns SS may be separated from each other in the first direction D1 by the second isolation insulating patterns STI2.

Gate insulating films GI that conformally cover the inner walls of the fourth horizontal regions HR4 and the first trenches T1 may be formed. Wordlines WL that fill parts of the fourth horizontal regions HR4 may be formed on the gate insulating films GI. The wordlines WL may be formed on the spacer insulating patterns SS.

The formation of the wordlines WL may involve forming a preliminary conductive pattern that fills the fourth horizontal regions HR4 and the first trenches T1 and then partially etching the preliminary conductive pattern to form the wordlines WL that fill parts of the fourth horizontal regions HR4. The partial etching of the preliminary conductive pattern may be performed using an etch-back technique.

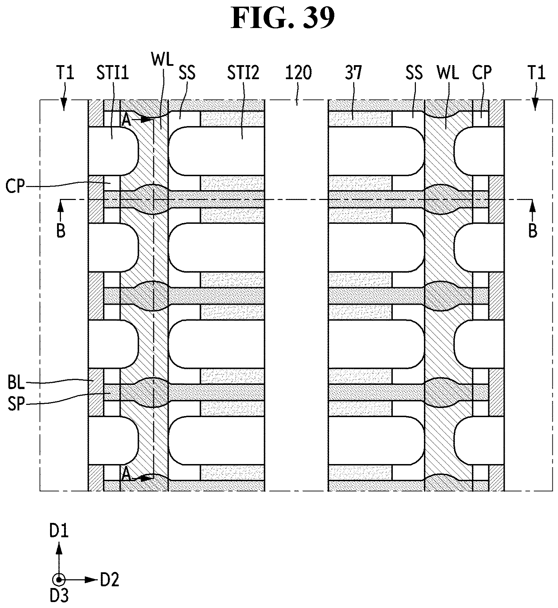

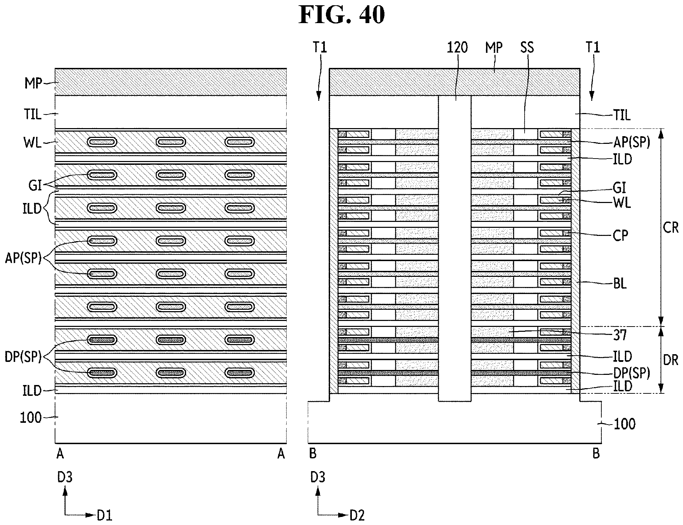

Referring to FIG. 39 and FIG. 40, capping insulating patterns CP may be formed that fill the fourth horizontal regions HR4 where the wordlines WL are formed. For instance, the capping insulating patterns CP may be formed to fill the remaining portions of the fourth horizontal regions HR4 (e.g. adjacent to the wordlines WL)

The formation of the capping insulating patterns CP may involve forming a capping insulating film on the inner walls of the first trench T1 to fill the fourth horizontal regions HR4 and then removing the capping insulating film from within the first trench T1 to expose the sidewalls of the interlayer insulating patterns ILD. The capping insulating film may be etched using an isotropic etching process with etch selectivity relative to the interlayer insulating patterns ILD and the semiconductor patterns SP.

Before or after forming the capping insulating patterns CP, parts of the semiconductor patterns SP exposed within the first trenches T1 may be doped with impurities. As a result, first impurity regions SD1 may be formed in the semiconductor patterns SP. The first impurity regions may be in contact with the bitlines BL. The first impurity regions may be formed using a gas-phase doping (GPD) process or a plasma doping (PLAD) process through the first trenches T1. The first impurity regions SD1 may be formed by doping ends of the semiconductor patterns SP exposed by the first trenches T1.

After forming the capping insulating patterns CP, the bitlines BL may be formed in the first trenches T1.

The formation of the bitlines BL may involve depositing a conductive film on the inner walls of the first trenches T1 to fill the spaces between the first isolation insulating patterns STI1 and then removing the conductive film from above the inner walls of the first trenches T1 to expose the sidewalls of the first isolation insulating patterns STI1. After forming the bitlines BL, the mask pattern MP may be removed.

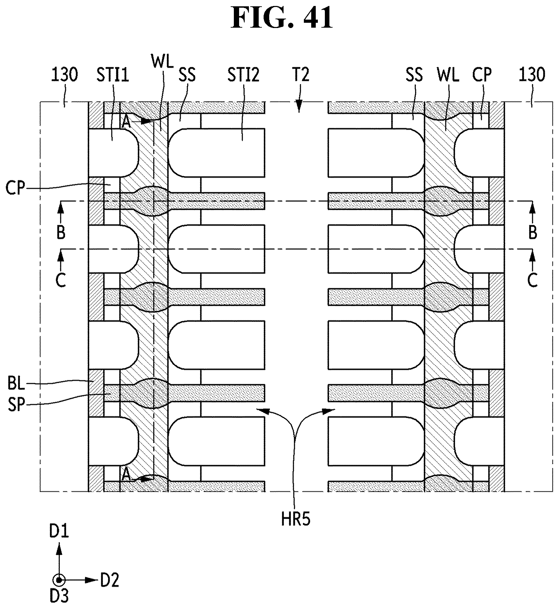

Referring to FIGS. 41-43, after forming the bitlines BL, buried insulating patterns 130 may be formed in the first trenches T1. The buried insulating patterns 130 may extend along the first direction D1 on the substrate 100.

Thereafter, by removing the second buried insulating pattern 120, the second trench T2 may be re-formed. The upper surface of the substrate 100, the sidewalls of the third sacrificial patterns 37, the sidewalls of the semiconductor patterns SP, and the sidewalls of the interlayer insulating patterns ILD may be exposed in the second trench T2.

Thereafter, the third sacrificial patterns 37 exposed in the second trench T2 may be removed to expose the spacer insulating patterns SS, thereby forming fifth horizontal regions HR5.

The formation of the fifth horizontal regions HR5 may involve isotropically etching the third sacrificial patterns 37 by performing an etching process with etch selectivity relative to the substrate 100, the semiconductor patterns SP, and the interlayer insulating patterns ILD. During the isotropic etching of the third sacrificial patterns 37, the spacer insulating patterns SS may be used as etch stoppers. The fifth horizontal regions HR5 may be formed vertically between the interlayer insulating patterns ILD and the semiconductor patterns SP, and horizontally between the second isolation insulating patterns STI2.

Thereafter, the length, in the second direction D2, of the semiconductor patterns SP may be reduced by etching parts of the semiconductor patterns SP exposed in the fifth horizontal regions HR5. That is, after forming the fifth horizontal regions HR5, parts of the semiconductor patterns SP may be isotropically etched.

Thereafter, referring to FIGS. 3-5, second impurity regions SD2 may be formed by doping parts of the semiconductor patterns SP with impurities. For instance, ends of the semiconductor patterns SP that are exposed by the fifth horizontal regions HR5 may be doped to form the second impurity regions SD2.

Thereafter, storage electrodes SE may be locally formed in the fifth horizontal regions HR5. The storage electrodes SE may be in contact with the second impurity regions SD2.

The formation of the storage electrodes SE may involve depositing a conductive film that conformally covers the inner walls of the fifth horizontal regions HR5 and the inner walls of the second trench T2, and then removing the conductive film from the inner walls of the second trench T2 to leave the conductive film locally within the fifth horizontal regions HR5.

The storage electrodes SE may be spaced apart from each other in the first, second, and third directions D1, D2, and D3, respectively. The storage electrodes SE may be in contact with the semiconductor patterns SP exposed in the fifth horizontal regions HR5. The storage electrodes SE may define hollow spaces within the fifth horizontal regions HR5. The storage electrodes SE may each have a long axis in the second direction D2 and be in the form of a hollow cylinder. In some embodiments, the storage electrodes SE may each have a pillar shape with a long axis in the second direction D2.

Thereafter, capacitor dielectric films CIL that conformally cover the storage electrodes SE formed in the fifth horizontal regions HR5 may be formed, and plate electrodes PE may be formed that fill the fifth horizontal regions HR5 and the second trench T2 where the storage electrodes SE and the capacitor dielectric films CIL are formed.

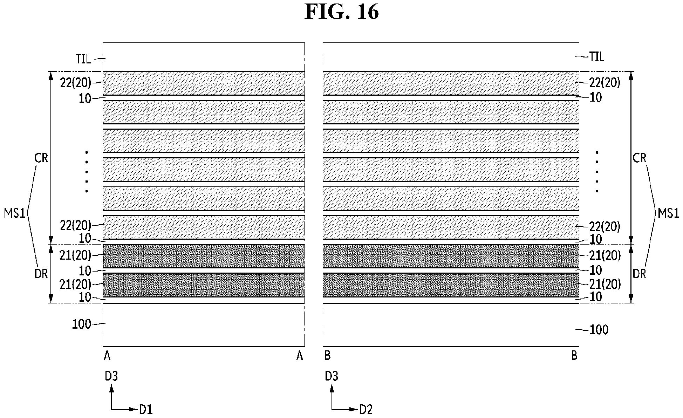

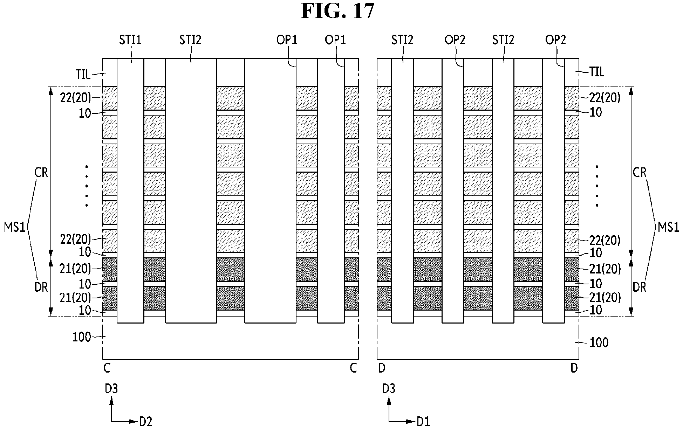

If the first sacrificial films 10 of FIG. 16 and FIG. 17 include SiGe, a semiconductor memory device with active patterns AP that do not contain C may be manufactured.

If the first sacrificial films 10 of FIG. 16 and FIG. 17 include SiGeC, C from the first sacrificial films 10 may diffuse into the active films 22, resulting in the formation of active patterns AP that contain C. In this case, the semiconductor memory device described above with reference to FIG. 13 and FIG. 14 may be manufactured.

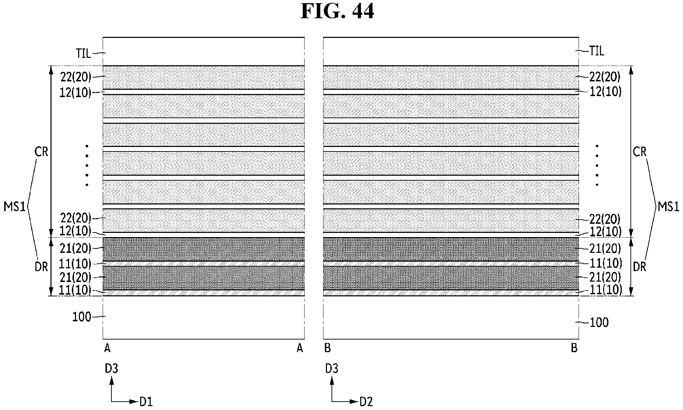

FIGS. 44-46 are diagrams for explaining methods for fabricating a semiconductor device according to some embodiments. For reference, FIGS. 44-46 are cross-sectional views taken along lines A-A and B-B of FIG. 3. For convenience, overlapping content with FIGS. 1-43 will be briefly described, with a focus on the differences.

Referring to FIG. 44, in some embodiments, first sacrificial films 10 may include a plurality of dummy sacrificial films 11 in a dummy region DR and a plurality of cell sacrificial films 12 in a cell region CR. In the dummy region DR of a first mold structure MS1, the plurality of dummy sacrificial films 11 and a plurality of dummy films 21 may be alternately stacked. In the cell region CR of the first mold structure MS1, the plurality of cell sacrificial films 12 and a plurality of active films 22 may be alternately stacked. The dummy sacrificial films 11 and the cell sacrificial films 12 may include materials with different tensile stresses (e.g. different lattice constants).

In some embodiments, the dummy sacrificial films 11 may include SiGeC, and the cell sacrificial films 12 may include SiGe. Thereafter, the steps described above with reference to FIGS. 18-43 may be performed, resulting in the fabrication of the semiconductor memory device of FIGS. 3-5. In this case, active patterns AP may not contain C.

In some embodiments, the dummy sacrificial films 11 may include SiGe, and the cell sacrificial films 12 may include SiGeC. Then, the C in the cell sacrificial films 12 may diffuse into the active films 22. Thereafter, the steps described above with reference to FIGS. 18-43 may be performed, resulting in the fabrication of the semiconductor memory device of FIGS. 3-5. In this case, a semiconductor memory device including active patterns AP that contain C, as described with reference to FIG. 13 and FIG. 14, may be manufactured.

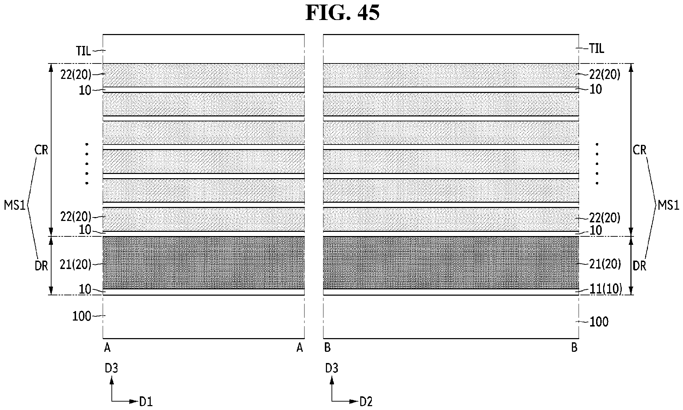

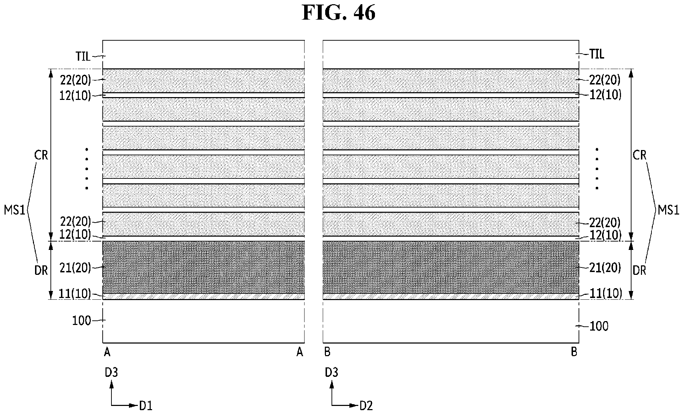

Referring to FIG. 45 and FIG. 46, in some embodiments, a dummy region DR may include a single dummy film 21. The dummy region DR may include the dummy film 21 and a first sacrificial film 10 that are sequentially stacked. Thereafter, the steps described above with reference to FIGS. 18-43 may be performed, resulting in the fabrication of the semiconductor memory device of FIG. 6. If the first sacrificial film 10 includes SiGe, a semiconductor memory device including active patterns AP that do not contain C may be manufactured. If the first sacrificial film 10 includes SiGeC, the C from the first sacrificial film 10 may diffuse into active films 22, resulting in the formation of active patterns AP that contain C. In this case, the semiconductor memory device of FIG. 13 and FIG. 14 may be manufactured.

Referring to FIG. 45, the first sacrificial film 10 may include the dummy sacrificial film 11 in the dummy region DR and a plurality of cell sacrificial films 12 in a cell region CR. The cell region CR may include the plurality of cell sacrificial films 12 and a plurality of active films 22 that are alternately stacked. The dummy sacrificial films 11 and the cell sacrificial films 12 may include materials with different tensile stresses.

Referring to FIG. 46, the dummy sacrificial film 11 in the dummy region DR and the cell sacrificial films 12 in the cell region CR may include materials with different tensile stresses.

In some embodiments, the dummy sacrificial film 11 may include SiGeC, and the cell sacrificial films 12 may include SiGe. Thereafter, the steps described above with reference to FIGS. 18-43 may be performed, resulting in the fabrication of the semiconductor memory device of FIG. 6. In this case, active patterns AP may not contain C.

In some embodiments, the dummy sacrificial film 11 may include SiGe, and the cell sacrificial films 12 may include SiGeC. Then, the C in the cell sacrificial films 12 may diffuse into the active films 22. Thereafter, the steps described above with reference to FIGS. 18-43 may be performed, resulting in the fabrication of the semiconductor memory device of FIG. 6. In this case, a semiconductor memory device including active patterns AP that contain C, as described with reference to FIG. 13 and FIG. 14, may be manufactured.

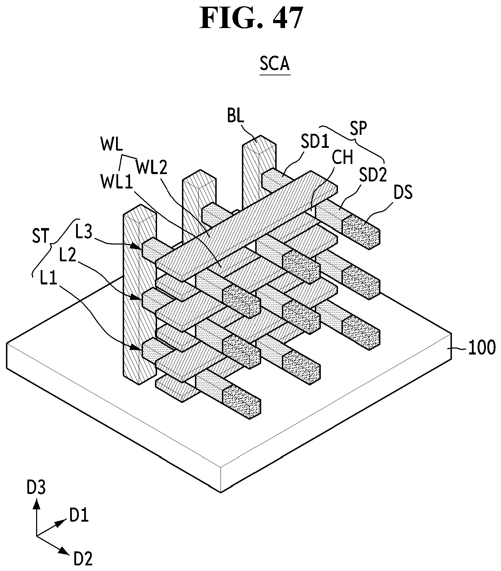

FIG. 47 is a perspective view illustrating a semiconductor memory device according to some embodiments. For convenience, overlapping content with FIGS. 1-46 will be briefly described, with a focus on the differences.

Referring to FIG. 47, in some embodiments, wordlines WL may include first wordlines WL1 on first sidewalls of semiconductor patterns SP and second wordlines WL2 on second sidewalls of the semiconductor pattern SP that face the first sidewalls. The first sidewalls and the second sidewalls may face each other in a third direction D3 (e.g. may be opposite each other in the third direction D3). As an example, the first sidewalls may be lower walls of the semiconductor pattern SP (e.g. may face towards the substrate 100). As an example, the second sidewalls may be upper walls of the semiconductor pattern SP (e.g. may face away from the substrate 100).

In some embodiments, the wordlines WL may be on only one of the opposing first and second sidewalls of each of the semiconductor patterns SP. For instance, the first wordlines WL1 or the second wordlines WL2 may be omitted.

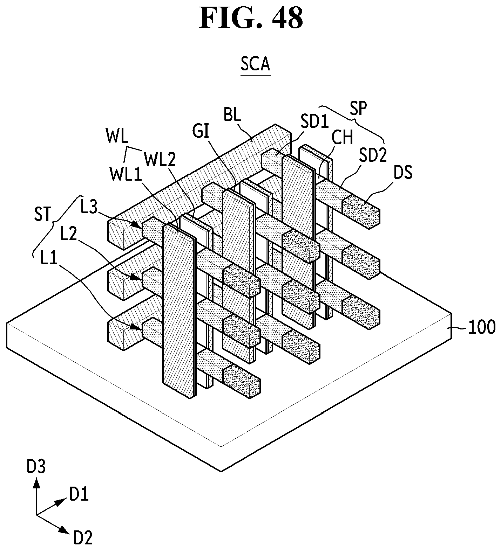

FIG. 48 is a perspective view illustrating a semiconductor memory device according to some embodiments. For convenience, overlapping content with FIGS. 1-47 will be briefly described, with a focus on the differences.

Referring to FIG. 48, in some embodiments, a plurality of bitlines BL extending in a first direction D1 may be on a substrate 100. The bitlines BL may have a linear shape or bar shape extending in the first direction D1. The bitlines BL may be arranged along a third direction D3. The bitlines BL may be electrically connected to first impurity regions SD1 of semiconductor patterns SP, which are arranged along the first direction D1.

Wordlines WL may have a linear shape or bar shape extending in the third direction D3. The wordlines WL may be stacked to be spaced apart from each other in the first direction D1. The wordlines WL may extend across a stack structure ST in the first direction D1.

In some embodiments, the wordlines WL may include first wordlines WL1 on first sidewalls of the semiconductor patterns SP and second wordlines WL2 on second sidewalls of the semiconductor patterns SP that face the first sidewalls. The first sidewalls and the second sidewalls may face each other in the first direction D1 (e.g. may be opposite each other in the first direction D1).

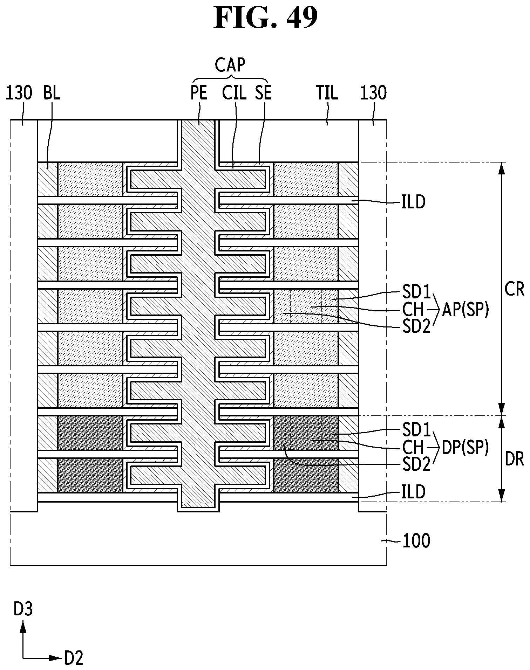

FIGS. 49-56 are views illustrating semiconductor memory devices according to some embodiments. For reference, FIGS. 49-56 are cross-sectional views, taken along a second direction D2, of semiconductor patterns SP of semiconductor memory devices according to some embodiments of the present disclosure that are stacked in a third direction D3. For convenience, overlapping content with FIGS. 1-48 will be briefly described, with a focus on the differences.

Referring to FIGS. 49-56, in some embodiments, the semiconductor patterns SP that are spaced apart from each other in the third direction D3 may be respectively connected to bitlines BL that are spaced apart from each other in the third direction D3.

Bitlines BL connected to dummy patterns DP may be dummy bitlines. No voltage may be applied to the dummy bitlines, and the dummy bitlines may be electrically floated.

Storage electrodes SE may extend along the upper surfaces and lower surfaces of interlayer insulating patterns ILD and along the side surfaces of the semiconductor patterns SP.

In some embodiments, active patterns AP may include Si and may not contain C. The active patterns AP may be formed from first sacrificial films 10 in FIG. 16 or cell sacrificial films 12 in FIGS. 44-46 that include SiGe.

In some embodiments, the active patterns AP may include Si and C. The active patterns AP may be formed from first sacrificial films 10 in FIG. 16 or cell sacrificial films 12 in FIGS. 44-46 that include SiGeC. As described above with reference to FIG. 13, the average concentration of C within each of the active patterns AP may vary, with higher concentrations closer to the substrate 100. As mentioned earlier with reference to FIG. 14, the concentration of C in the active pattern AP may differ between lower surfaces APbs and upper surfaces APus. The concentration of C in the active patterns AP may decrease and then increase along the direction from the lower surfaces APbs to the upper surfaces APus.

Referring to FIG. 49, in some embodiments, a dummy region DR may include a plurality of interlayer insulating patterns ILD and a plurality of dummy patterns DP that are alternately stacked. A cell region CR may include a plurality of interlayer insulating patterns ILD and a plurality of active patterns AP that are alternately stacked.

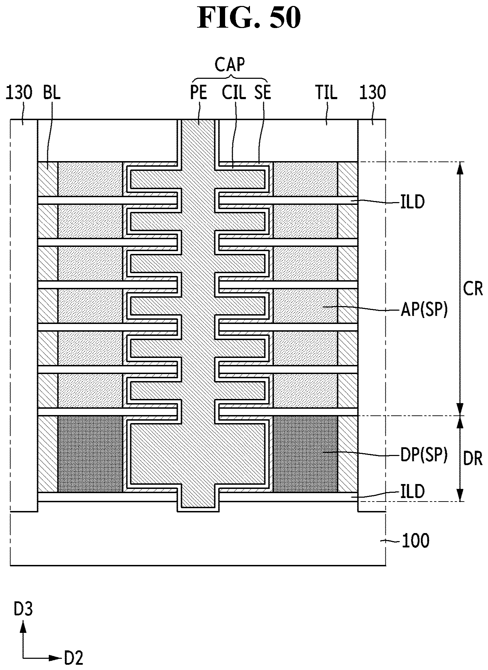

Referring to FIG. 50, in some embodiments, a dummy region DR may include a single dummy pattern DP. The thickness, in the third direction D3, of the dummy pattern DP may be greater than the thickness, in the third direction D3, of active patterns AP.

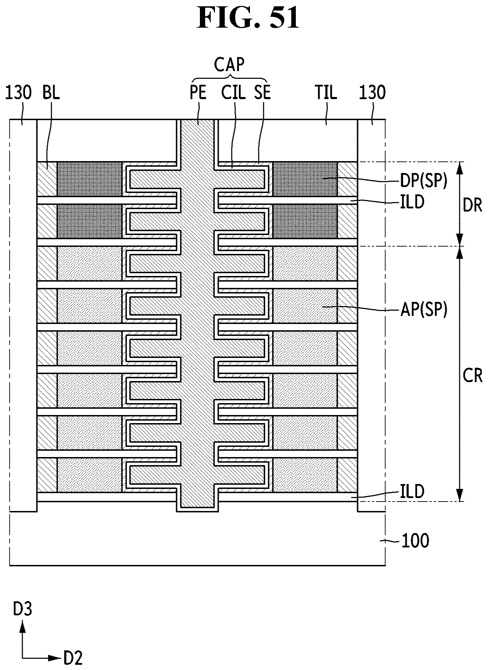

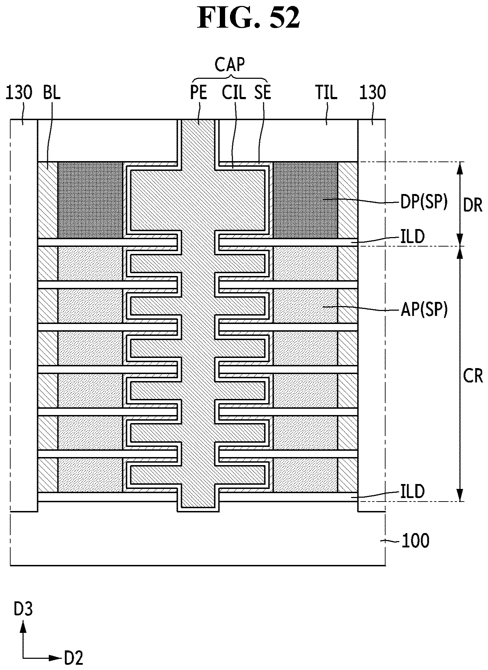

Referring to FIGS. 51 and 52, in some embodiments, a cell region CR may be between a substrate 100 and a dummy region DR. The dummy region DR may be above the cell region CR.

Referring to FIG. 51, in some embodiments, a dummy region DR may include a plurality of dummy patterns DP.

Referring to FIG. 52, in some embodiments, a dummy region DR may include a single dummy pattern DP. The thickness, in the third direction D3, of the dummy pattern DP may be greater than the thickness, in the third direction D3, of active patterns AP.

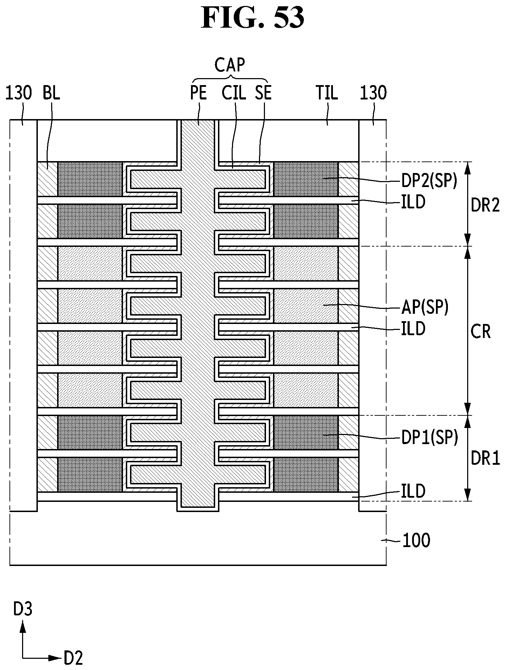

Referring to FIGS. 53-56, in some embodiments, the semiconductor memory devices according to some embodiments may each include a first dummy region DR1, a second dummy region DR2, and a cell region CR. The first dummy region DR1 may be below the cell region CR, and the second dummy region DR2 may be above the cell region CR. The cell region CR may be between the first and second dummy regions DR1 and DR2. The thickness, in the third direction D3, of the first dummy region DR1 may be the same as or different from the thickness, in the third direction D3, of the second dummy region DR2.

The semiconductor patterns SP may include at least one first dummy pattern DP1 in the first dummy region DR1, a plurality of active patterns AP in the cell region CR, and at least one second dummy pattern DP2 in the second dummy region DR2.

In some embodiments, the first and second dummy patterns DP1 and DP2 may include a first element (e.g., C or B) with a smaller atomic size than Si. The average concentration of the first element in the first dummy pattern DP1 may be the same as or different from the average concentration of the first element in the second dummy pattern DP2.

In some embodiments, the first and second dummy patterns DP1 and DP2 may include different first and second elements, respectively, with a smaller atomic size than Si. For example, one of the first and second dummy patterns DP1 and DP2 may include C, and the other dummy pattern may include B.

Referring to FIG. 53, in some embodiments, the first dummy region DR1 may include a plurality of first dummy patterns DP1. The first dummy region DR1 may include a plurality of interlayer insulating patterns ILD and a plurality of first dummy patterns DP1 that are alternately stacked. The second dummy region DR2 may include a plurality of second dummy patterns DP2. The second dummy region DR2 may include a plurality of interlayer insulating patterns ILD and a plurality of second dummy patterns DP2 that are alternately stacked.

The number of first dummy patterns DP1 and the number of second dummy patterns DP2 may be the same or different.

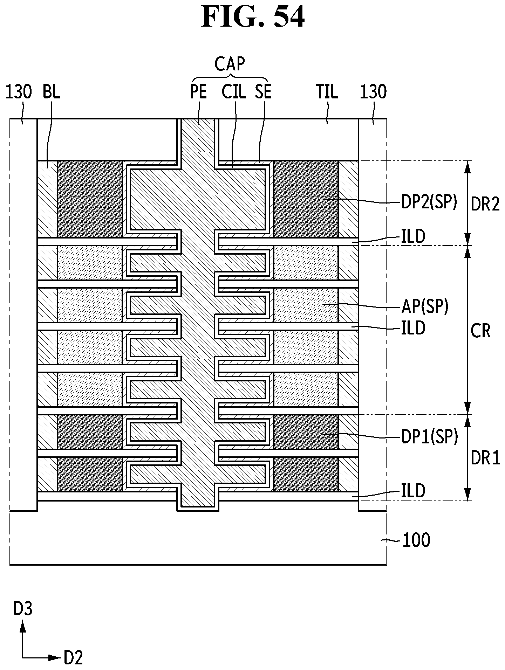

Referring to FIG. 54, in some embodiments, the first dummy region DR1 may include a plurality of first dummy patterns DP1, and the second dummy region DR2 may include a single second dummy pattern DP2. The thickness, in the third direction D3, of the first dummy patterns DP1 may be smaller than the thickness, in the third direction D3, of the second dummy pattern DP2.

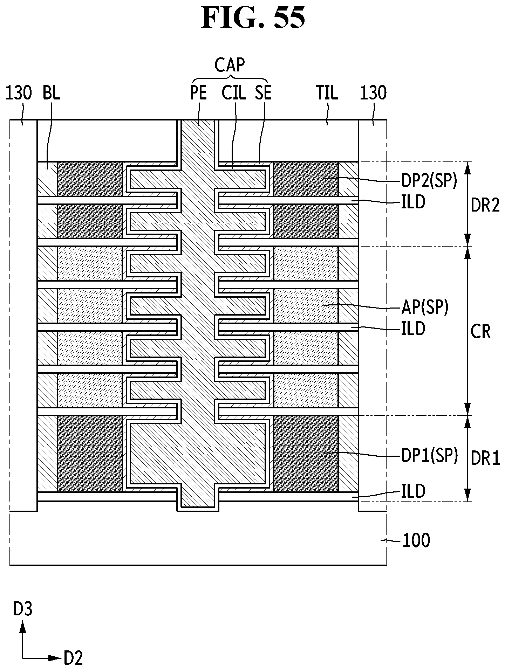

Referring to FIG. 55, in some embodiments, the first dummy region DR1 may include a single first dummy pattern DP1, and the second dummy region DR2 may include a plurality of second dummy patterns DP2. The thickness, in the third direction D3, of the second dummy patterns DP2 may be smaller than the thickness, in the third direction D3, of the first dummy pattern DP1.

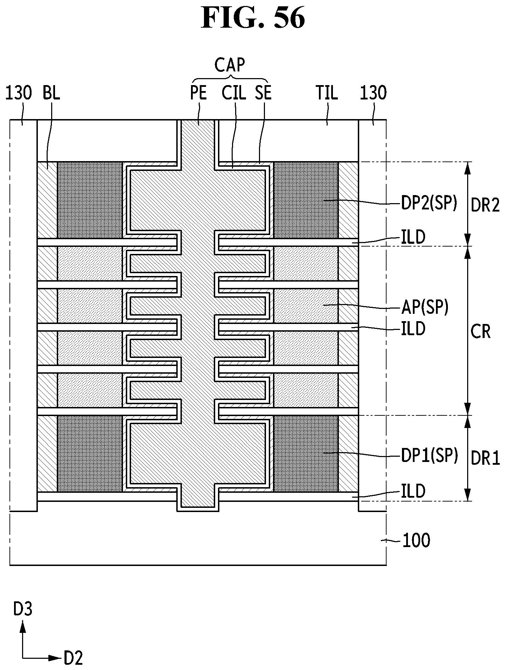

Referring to FIG. 56, in some embodiments, the first dummy region DR1 may include a single first dummy pattern DP1, and the second dummy region DR2 may include a single second dummy pattern DP2. The thickness, in the third direction D3, of the first dummy pattern DP1 may be the same as or different from the thickness, in the third direction D3, of the second dummy pattern DP2.

Embodiments are set out in the following Clauses:
Clause 1. A semiconductor memory device comprising:
   a substrate;
   a plurality of semiconductor patterns on the substrate, wherein ones of the plurality of semiconductor patterns are spaced apart from each other in a first direction parallel to an upper surface of the substrate;
   a plurality of wordlines electrically connected to the plurality of semiconductor patterns;
   a plurality of bitlines electrically connected to a plurality of first ends of the plurality of semiconductor patterns, respectively; and
   a plurality of data storage devices electrically connected to respective ones of a plurality of second ends of the plurality of semiconductor patterns,
   wherein the plurality of semiconductor patterns includes at least one dummy pattern and a plurality of active patterns,
   wherein the at least one dummy pattern is on a respective at least one upper side and/or on a respective at least one lower side of the plurality of active patterns, and
   wherein the at least one dummy pattern includes a first element with an atomic radius that is less than an atomic radius of silicon.
Clause 2. The semiconductor memory device of Clause 1, wherein the plurality of wordlines extend in the first direction, and
   wherein the plurality of bitlines extend in a third direction perpendicular to the substrate.
Clause 3. The semiconductor memory device of Clause 1, wherein the plurality of wordlines extend in a second direction parallel to the substrate, and
   wherein ones of the plurality of bitlines are spaced apart from each other in the first direction.
Clause 4. The semiconductor memory device of any preceding Clause, wherein the first element of the at least one dummy pattern includes carbon or boron.
Clause 5. A method for fabricating a semiconductor memory device, comprising:
   forming a mold structure that includes a dummy region and a cell region, and includes a plurality of sacrificial films and a plurality of semiconductor films alternately stacked on a substrate,
      wherein the plurality of semiconductor films includes at least one dummy film in the dummy region and a plurality of active films in the cell region;
   forming a plurality of horizontal regions between the plurality of semiconductor films by removing the plurality of sacrificial films; and
   forming a plurality of semiconductor patterns by etching a plurality of upper surfaces and a plurality of lower surfaces of the plurality of semiconductor films exposed by the plurality of horizontal regions,
      wherein the plurality of semiconductor patterns includes at least one dummy pattern formed by etching the at least one dummy film and a plurality of active patterns formed by etching the plurality of active films,
   wherein the plurality of sacrificial films includes a compressive stress material, and
   wherein the at least one dummy film includes a tensile stress material.
Clause 6. The method of Clause 5, wherein the plurality of sacrificial films include SiGe or SiGeC.
Clause 7. The method of Clause 5 or Clause 6, wherein the at least one dummy film includes a first element with an atomic radius that is less than an atomic radius of silicon.
Clause 8. The method of any of Clauses 5-7, wherein the plurality of semiconductor films include a single dummy film in the dummy region, and
   wherein a first thickness of the single dummy film is greater than a second thickness of the active films.
Clause 9. The method of any of Clauses 5-7, wherein the dummy region includes a first dummy region and a second dummy region, and
   wherein the cell region is between the first and second dummy regions.
Clause 10. The method of any of Clauses 5-9, wherein the dummy region is on an upper side and/or a lower side of the cell region.
Clause 11. A semiconductor memory device comprising:
   a substrate;
   a plurality of semiconductor patterns on the substrate, wherein ones of the plurality of semiconductor patterns are spaced apart from each other in a first direction parallel to an upper surface of the substrate;
   a plurality of interlayer insulating patterns respectively between adjacent ones of the plurality of semiconductor patterns in a third direction; and
   a plurality of data storage devices electrically connected to respective ones the plurality of semiconductor patterns,
   wherein the plurality of semiconductor patterns includes at least one dummy pattern and a plurality of active patterns, and
   wherein the at least one dummy pattern includes silicon and carbon.
Clause 12. The semiconductor memory device of Clause **11,** further comprising:
   a plurality of wordlines electrically connected to the plurality of semiconductor patterns;
   wherein the plurality of wordlines includes a plurality of first wordlines and a plurality of second wordlines,
   wherein the plurality of first wordlines are on a plurality of first sidewalls of the plurality of semiconductor patterns, and
   wherein the plurality of second wordlines are on a plurality of second sidewalls of the plurality of semiconductor patterns.
Clause 13. The semiconductor memory device of Clause 11 or Clause 12, wherein a concentration of carbon at a lower surface of the plurality of active patterns is different from a concentration of carbon at an upper surface of the plurality of active patterns.
Clause 14. The semiconductor memory device of Clause 13, wherein the concentration of carbon in the plurality of active patterns decreases and then increases from the lower surface to the upper surface of respective ones of the plurality of active patterns.
Clause 15. The semiconductor memory device of any of Clauses 11-14, wherein the plurality of semiconductor patterns has a convex shape in the first direction along the plurality of semiconductor patterns in a second direction.
Clause 16. The semiconductor memory device of any of Clauses 11-15, further comprising:
   a plurality of wordlines electrically connected to the plurality of semiconductor patterns,
   wherein the plurality of wordlines extends over a portion of respective ones of a plurality of first isolation insulating patterns and are in contact with respective ones of a plurality of second isolation insulating patterns.
The embodiments of the present disclosure have been described above with reference to the accompanying drawings. However, the present disclosure is not limited to these embodiments and may be embodied in various other forms. It will be understood that those skilled in the art may make modifications and variations in form or detail without departing from the scope of the following claims. Therefore, the example embodiments described above should be considered as illustrative and non-limiting in all respects.

## Claims

1. A semiconductor memory device comprising:
a substrate (100);
a plurality of semiconductor patterns (SP) on the substrate (100), wherein ones of the plurality of semiconductor patterns (SP) are spaced apart from each other in a first direction parallel to an upper surface of the substrate;
a plurality of interlayer insulating patterns (ILD) respectively between adjacent ones of the plurality of semiconductor patterns (SP) in a third direction; and
a plurality of data storage devices (DS) electrically connected to respective ones the plurality of semiconductor patterns (SP),
wherein the plurality of semiconductor patterns (SP) includes at least one dummy pattern (DP)) and a plurality of active patterns (AP), and
wherein the at least one dummy pattern (DP) includes a first element with an atomic radius that is less than an atomic radius of silicon.

2. The semiconductor memory device of claim 1, wherein the at least one dummy pattern (DP) is between the substrate (100) and the plurality of active patterns (AP).

3. The semiconductor memory device of claim 1, wherein the plurality of active patterns (AP) are between the substrate (100) and the at least one dummy pattern (DP).

4. The semiconductor memory device of claim 1, wherein the at least one dummy pattern (DP) includes at least one first dummy pattern (DP1) and at least one second dummy pattern (DP2), and
wherein the plurality of active patterns (AP) are between the at least one first dummy pattern (DP1) and the at least one second dummy pattern (DP2).

5. The semiconductor memory device of any preceding claim, wherein the plurality of active patterns (AP) include silicon and do not include carbon.

6. The semiconductor memory device of any of claims 1-4, wherein the plurality of active patterns (AP) include silicon and carbon.

7. The semiconductor memory device of any of claims 1-4 or 6, wherein the plurality of active patterns (AP) include a first active pattern (AP1) and a second active pattern (APn), wherein the first active pattern (AP1) and the second active pattern (APn) include carbon, and
wherein a concentration of carbon in the first active pattern (AP1) is different from a concentration of carbon in the second active pattern (APn).

8. The semiconductor memory device of claim 7, wherein the first active pattern (AP1) is between the substrate (100) and the second active pattern (APn), and
wherein the concentration of carbon in the first active pattern (AP1) is greater than the concentration of carbon in the second active pattern (APn).

9. The semiconductor memory device of claim 1, wherein the plurality of active patterns (AP) include a first active pattern (AP1) that includes carbon,
wherein the first active pattern (AP1) includes a first surface (APbs) and a second surface (APus) that are parallel to each other, and
wherein a concentration of carbon at the first surface (APbs) of the first active pattern (AP1) is different from a concentration of carbon at the second surface (APus) of the first active pattern (AP1).

10. The semiconductor memory device of claim 9, wherein the first surface (APbs) faces the substrate (100), and wherein the concentration of carbon at the first surface (APbs) of the first active pattern (AP1) is greater than the concentration of carbon at the second surface (APus) of the first active pattern (AP1).

11. The semiconductor memory device of any preceding claim, wherein:
the semiconductor memory device further comprises:
a plurality of wordlines (WL) electrically connected to the plurality of semiconductor patterns (SP); and
a plurality of bitlines (BL) electrically connected to a plurality of first ends of the plurality of semiconductor patterns (SP), respectively;
the plurality of data storage devices (DS) are electrically connected to respective ones of a plurality of second ends of the plurality of semiconductor patterns (SP); and
the at least one dummy pattern (DP) is on a respective at least one upper side (APus) and/or on a respective at least one lower side (APbs) of the plurality of active patterns (AP).

12. The semiconductor memory device of claim 11, wherein the plurality of wordlines (WL) extend in the first direction, and
wherein the plurality of bitlines (BL) extend in the third direction, wherein the third direction is perpendicular to the substrate (100).

13. The semiconductor memory device of claim 11, wherein the plurality of wordlines extend in a second direction parallel to the substrate (100), and
wherein ones of the plurality of bitlines (BL) are spaced apart from each other in the first direction.

14. The semiconductor memory device of any of preceding claim, wherein the first element of the at least one dummy pattern (DP) includes carbon or boron.

15. The semiconductor memory device of any preceding claim wherein the at least one dummy pattern (DP) includes silicon and carbon.
